# EUROPEAN PATENT APPLICATION

(11) **EP 4 553 518 A1**
(43) Date of publication of application: **14.05.2025**
(21) Application number: 22955099.1
(22) Date of filing: 01.09.2022
(51) Int. Cl.: G01R 31/371, G01R 31/392, G01R 31/382, H01M 10/42, H01M 10/48, H02J 7/00

(54) **BATTERY MODULE COMPRISING BATTERY MANAGEMENT SYSTEM**

(30) Priority: 08.08.2022 KR 20220098768; 08.08.2022 KR 20220098773
(71) Applicant: Bu Myeong., Ltd., Suwon-si, Gyeonggi-do 16229 (KR)
(72) Inventor: KIM, Chulhoon, Anyang-si Gyeonggi-do 14071 (KR)
(74) Representative: BCKIP Part mbB
(86) International application number: PCT/KR2022/013124
(87) International publication number: WO 2024/034726

(57) **Abstract**

A battery module comprises: a plurality of battery cells including a first battery cell and a second battery cell; a master battery management system (BMS) for managing the plurality of battery cells; a bus bar which connects the plurality of battery cells and is connected to the master BMS; and a switch configured to electrically connect or separate the first battery cell and the second battery cell. The first battery cell includes a first cell controller. The first cell controller obtains first data related to the deterioration of the first battery cell and is configured to control the switch so that the first battery cell is electrically separated from the second battery cell when it is determined on the basis of the first data that the first battery cell has deteriorated.

## Description

### [Technical Field]

The present disclosure relates to a battery module comprising a battery management system.

### [Background Art]

A battery module may be configured with a plurality of electrically connected battery cells. The plurality of battery cells may be connected in series and/or in parallel with each other. Each of the plurality of battery cells may age at different rates.

The battery module may include a battery management system (BMS) for monitoring states of the plurality of battery cells. The battery management system may transmit and/or receive a data signal with the plurality of battery cells, in order to monitor the plurality of battery cells constituting the battery module and control operations of the battery cells.

### [Disclosure]

### [Technical Problem]

In order for the BMS to monitor and control each of the plurality of battery cells, the BMS and the plurality of battery cells are required to be electrically connected to each other. For example, the battery module may include a wire harness electrically connecting the BMS with each of the plurality of battery cells. As the number of the plurality of battery cells constituting the battery module increases, the number and length of the wire harness may increase. Therefore, the design of the battery module may become complex, and the weight may become heavy.

The BMS may manage SOH of the plurality of battery cells. When a deteriorated battery cell among the plurality of battery cells is present, the overall performance of the battery module may be degraded. The BMS may perform an operation of identifying a deteriorated battery cell and separating the identified battery cell from other battery cells. However, it is difficult to identify a deteriorated battery cell, and a separate experiment such as performing separate charging and discharging may be required to measure the SOH of each of the plurality of battery cells. Furthermore, when the BMS identifies a deteriorated battery cell, it is required to stop the operation of the entire system and separate the deteriorated battery cell directly.

The technical problems to be achieved in this document are not limited to those described above, and other technical problems not mentioned herein will be clearly understood by those having ordinary knowledge in the art to which the present disclosure belongs, from the following description.

### [Technical Solution]

According to an embodiment, a battery module may comprise a plurality of battery cells, a master battery management system (BMS), a bus bar, and a switch. The plurality of battery cells may include a first battery cell and a second battery sell. The master BMS may be configured to manage the plurality of battery cells. The bus bar may connect the plurality of battery cells to each other. The bus bar may be electrically connected to the master BMS. The switch may be configured to electrically connect the first battery cell and the second battery cell or electrically disconnect the first battery cell and the second battery cell. The first battery cell may include a first cell controller configured to communicate with the master BMS via the bus bar. The first cell controller may be configured to obtain first data related to a deterioration of the first battery cell. The first cell controller may be configured to control the switch to electrically disconnect the first battery cell from the second battery cell, in accordance with determining the deterioration of the first battery cell based on the first data.

According to an embodiment, a battery module may comprise a plurality of battery cells, a master BMS, a bus bar, a plurality of cell controllers, and a switch. The plurality of battery cells may include a first battery cell and a second battery sell. The master BMS may be configured to manage the plurality of battery cells. The bus bar may connect the plurality of battery cells to each other. The bus bar may be electrically connected to the master BMS. The plurality of cell controllers may be configured to communicate with the master BMS via the bus bar, wherein each of the plurality of cell controllers is disposed in each of the plurality of battery cells. The switch may be configured to electrically connect the first battery cell and the second battery cell or electrically disconnect the first battery cell and the second battery cell. The master BMS may be configured to set a reference range based on data related a deterioration of each of the plurality of battery cells. The master BMS may be configured to identify a deteriorated battery cell among the plurality of battery cells, based on the reference range. The master BMS may be configured to control the switch, via one of the plurality of cell controllers, to electrically disconnect the deteriorated battery cell from other battery cells, based on identifying the deteriorated battery cell.

### [Advantageous Effects]

In a battery module according to an embodiment, each of a master BMS and a plurality of battery cells can communicate via a bus bar, and thus a separate wire harness may be omitted. According to an embodiment, since the wire harness is omitted, the design can be facilitated, and the weight can be lightened.

The effects that can be obtained from the present disclosure are not limited to those described above, and any other effects not mentioned herein will be clearly understood by those having ordinary knowledge in the art to which the present disclosure belongs, from the following description.

### [Description of the Drawings]

FIG. 1 is a schematic block diagram of a battery module according to an embodiment.
FIG. 2 is a schematic block diagram of a cell controller according to an embodiment.
FIG. 3 illustrates an example of a first battery cell constituting a battery module according to an embodiment.
FIG. 4 illustrates an example of a data packet of a signal transmitted and received through a cell controller of a battery module according to an embodiment.
FIG. 5 illustrates an example of an operation of transmitting and receiving a data signal of a plurality of battery cells of a battery module according to an embodiment.
FIG. 6 illustrates an example of a battery module according to an embodiment.
FIG. 7 illustrates an example of a switch of a battery module according to an embodiment.
FIG. 8 is a flowchart illustrating an example of an operation for separating a battery cell in which a master BMS of a battery module is deteriorated, according to an embodiment.
FIG. 9 is a flowchart illustrating an example of an operation in which a cell controller of a battery module separates a deteriorated battery cell, according to an embodiment.
FIG. 10 is a flowchart illustrating an example of an operation in which a master BMS of a battery module separates a deteriorated battery cell based on data recorded in memory of a cell controller, according to an embodiment.
FIGS. 11A and 11B illustrate an example of a switch of a battery module according to an embodiment.
FIG. 12 is a flowchart illustrating an example of an operation in which a master BMS of a battery module separates a deteriorated battery cell, according to an embodiment.
FIG. 13 is a flowchart illustrating an example of an operation in which a master BMS sets a reference range.
FIG. 14 is a flowchart illustrating an example of an operation in which a cell controller of a battery module separates a deteriorated battery cell, according to an embodiment.

### [Mode for Invention]

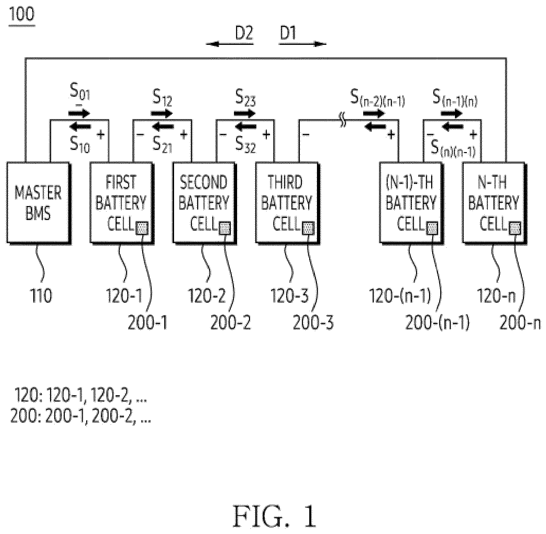

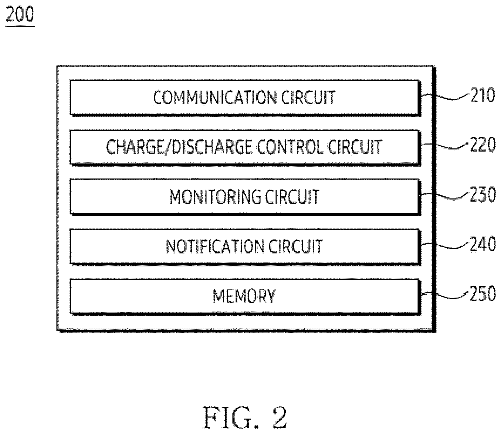

FIG. 1 is a schematic block diagram of a battery module according to an embodiment. FIG. 2 is a schematic block diagram of a cell controller according to an embodiment.

Referring to FIG. 1, a battery module 100 according to an embodiment may include a plurality of battery cells 120 connected to each other in series and a battery management system (BMS) 110 operably coupled to the plurality of battery cells 120. The plurality of battery cells 120 may be connected to each other in series to configure the battery module 100. Although not illustrated in FIG. 1, the plurality of battery cells 120 may operate as a driving source of a load by being connected with the load through an inverter or a pulse generator. A circuit described below may refer to a circuit including circuit elements interconnected to provide a specific function.

According to an embodiment, the plurality of battery cells 120 may be connected to each other in series. Referring to FIG. 1, a first battery cell 120-1 may be connected to the master BMS 110. A second battery cell 120-2 may be connected to the first battery cell 120-2. A third battery cell 120-3 may be connected to the second battery cell 120-2. According to an embodiment, the first 120-1 to nth battery cell 120-n may be sequentially connected in series in a first direction D1. For example, a negative terminal of the first battery cell 120-1 and a positive terminal of the second battery cell 120-2 may be electrically connected to each other. A negative terminal of the second battery cell 120-2 and a positive terminal of the third battery cell 120-3 may be electrically connected to each other. When the plurality of battery cells 120 are connected to each other in series, a voltage of the entire system may be set to the sum of each of the battery cells 120 constituting the plurality of battery cells 120. Although FIG. 1 illustrates that the plurality of battery cells 120 are arranged in the first direction D1, it is only for describing electrical connection of the plurality of battery cells 120, but is not limited thereto. For example, the plurality of battery cells 120 may be stacked and assembled with each other to form the battery module 100.

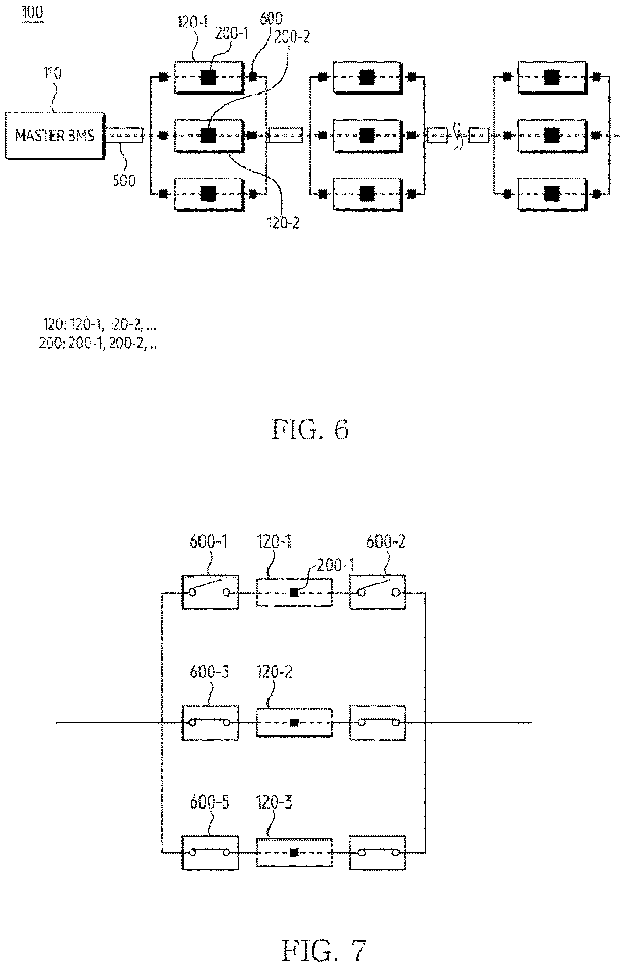

According to an embodiment, the master BMS 110 may be configured to control the overall operation of the plurality of battery cells 120. According to an embodiment, the master BMS 110 may be configured to communicate with a plurality of cell controllers 200 of the plurality of battery cells 120, via a bus bar (e.g., a bus bar 500 of FIG. 6) for connecting the plurality of battery cells 120, without a separate wire harness. The master BMS 110 may be configured to obtain information on SOH of each of the plurality of battery cells 120, via the bus bar. For example, the master BMS 110 may be configured to obtain information on the voltage and/or current of each of the plurality of battery cells 120, via the bus bar. For example, the master BMS 110 may be configured to obtain, via the bus bar, information on a state of each of the plurality of battery cells 120, such as a state of charge (SOC), a state of health (SOH), and a temperature of the plurality of battery cells 120. For example, the master BMS 110 may be configured to transmit a signal to request charging and/or discharging for each of the plurality of battery cells 120, to the plurality of cell controllers 200 disposed within the plurality of battery cells 120, via the bus bar.

According to an embodiment, the master BMS 110 may include the plurality of cell controllers 200 disposed in each of the battery cells 120 to collect information on a state of the plurality of battery cells 120. For example, the first battery cell 120-1 may include a first cell controller 200-1 disposed in the first battery cell 120-1. The second battery cell 120-2 may include a second cell controller 200-2 disposed within the second battery cell 120-2. For example, the plurality of cell controllers 200 may be disposed on a power line in the plurality of battery cells 120. The plurality of cell controllers 200 may be configured to transmit and/or receive data using a power line as a transmission medium. According to an embodiment, the plurality of battery cells 120 may transmit a signal including information on each state to the master BMS 110, by using the plurality of cell controllers 200. The master BMS 110 may transmit, to each of the plurality of battery cells 120 using the plurality of cell controllers 200, a signal to request an operation of each of the plurality of battery cells 120 and/or a signal to request information on SOH of each of the plurality of battery cells 120.

Referring to FIG. 2, the master BMS 110 may include a communication circuit 210, a charge/discharge control circuit 220, a monitoring circuit 230, a notification circuit 240, and memory 119.

According to an embodiment, the communication circuit 210 may transmit and/or receive a signal via a cell communication module 125 of the plurality of battery cells 120 and the bus bar. The communication circuit 210 may be connected to a power line for data signal transmission and power supply with the battery cells 120.

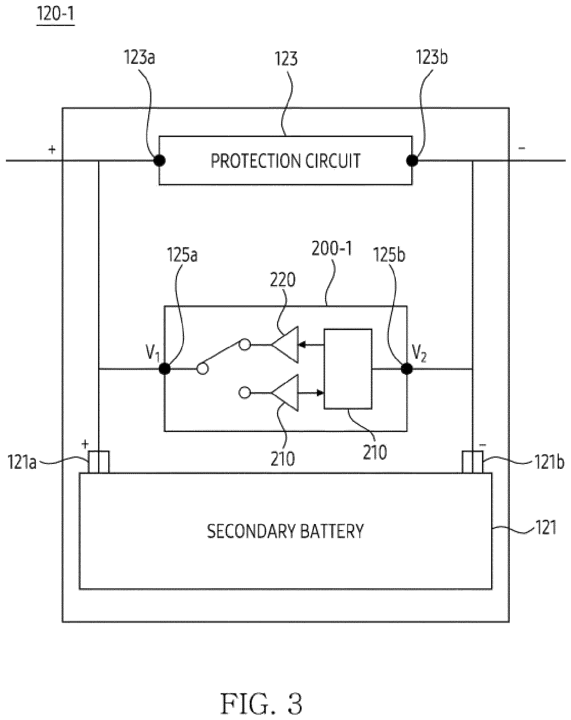

According to an embodiment, the charge/discharge control circuit 220 may control charging and/or discharging of the plurality of battery cells 120. For example, the charge/discharge control circuit 220 may perform a function of monitoring a voltage of a secondary battery (e.g., a secondary battery 121 of FIG. 3) in the plurality of battery cells 120 and a state of charge (SOC), a control function of charging and discharging of the plurality of battery cells 120, and a function for preventing over-charge and over-discharge.

According to an embodiment, the monitoring circuit 230 may be configured to monitor a state of the plurality of battery cells 120. The monitoring circuit 230 may notify the abnormality of the battery cells 120 through the notification circuit 240 when an abnormal state occurs. For example, the notification circuit 240 may be connected to a light emitting diode (LED), and a display transmitting a visual signal. For example, the notification circuit 240 may be connected to a speaker transmitting an audio signal. However, it is not limited thereto.

According to an embodiment, the memory 119 may be configured to store various information on the plurality of battery cells 120. For example, the memory 119 may store a unique ID and a state for each of the plurality of battery cells 120. For example, the memory 119 may store an ID table of battery cells 120 to be described later. For example, the memory 119 may store information on charge/discharge records, charge capacity, and remaining life of the battery cells 120.

According to an embodiment, an ID may be assigned to each of the plurality of battery cells 120. A signal transmitted from the master BMS 110 and a signal transmitted from the battery cells 120 may include information on an ID assigned to each of the plurality of battery cells 120. According to an embodiment, when a signal is received from the master BMS 110 to the plurality of cell controllers 200, the plurality of cell controllers 200 may be configured to identify information on an ID included in the signal. The plurality of cell controllers 200 may be configured to identify a battery cell to be a reception target of a signal received from the master BMS 110, based on information on the identified ID.

For example, when the master BMS 110 transmits a signal to request a specified operation to the third battery cell 120-3, the master BMS 110 may transmit a signal including information on an ID assigned to the third battery cell 120-3 to the first battery cell 120-1. The first cell controller 200-1 disposed in the first battery cell 120-1 may be configured to receive the signal and identify information on an ID included in the signal. The first cell controller 200-1 may identify that the information on an ID included in the signal does not match information on an ID assigned to the first battery cell 120-1, and transmit the signal to the second battery cell 120-2 based on the identification. The second cell controller 200-2 disposed in the second battery cell 120-2 may be configured to receive the signal, and identify information on an ID included in the signal. The second cell controller 200-2 may identify that the information on an ID included in the signal does not match information on an ID assigned to the second battery cell 120-2, and transmit the signal to the third battery cell 120-3 based on the identification. The third cell controller 200-3 disposed in the third battery cell 120-3 may be configured to receive the signal, and identify information on an ID included in the signal. The third cell controller 200-3 may identify that the information on an ID included in the signal matches the information on an ID assigned to the third battery cell 120-3, and identify a designated operation included in the signal, based on the identification. The third cell controller 200-3 may be configured to perform at least one or more operations corresponding to the designated operation, in order to perform the designated operation.

For example, when a signal including information on a state of the first battery cell 120-1 is transmitted to the master BMS 110, the master BMS 110 may identify the signal as a signal related to the first battery cell 120-1, through the information on an ID included in the signal. For example, when the plurality of battery cells 120 receive a signal including information on the charging and/or discharging of the first battery cell 120-1, the plurality of battery cells 120 may identify the signal as a signal related to the first battery cell 120-1 through the information on an ID included in the signal.

Since the battery module 100 according to an embodiment may communicate through a bus bar connecting the plurality of battery cells 120, the design for transmitting and/or receiving communication between the master BMS 110 and the plurality of battery cells 120 may be simplified.

According to an embodiment, when the master BMS 110 transmits a signal to a specific battery cell (e.g., the second battery cell 120-2), the signal may be transmitted through a battery cell (e.g., the first battery cell 120-1) other than a battery cell (e.g., the second battery cell 120-2), which is to be a reception target of the signal. In addition, when a specific battery cell (e.g., the second battery cell 120-2) transmits a signal to the master BMS 110, the signal may be transmitted to the master BMS 110 through at least another battery cell (e.g., the first battery cell 120-1).

For example, when the master BMS 110 transmits a signal to request information on a state of the third battery cell 120-3 to the third battery cell 120-3, the master BMS 110 may transmit a signal S₀₁ to the first battery cell 120-1 connected to the master BMS 110. The signal S₀₁ may be transmitted in the first direction D1. After the signal S₀₁ is transmitted to the first battery cell 120-1 connected to the master BMS 110, it may be changed into a signal S₁₂ transmitted from the first battery cell 120-1 to the second battery cell 120-2. After being transmitted to the second battery cell 120-2, the signal S₁₂ transmitted from the first battery cell 120-1 to the second battery cell 120-2 may be changed into a signal S₂₃ transmitted from the second battery cell 120-2 to the third battery cell 120-3.

For example, when the third battery cell 120-3 transmits a signal including information on a state of the third battery cell 120-3 to the master BMS 110, the signal may be transferred in a second direction D2. The signal S₃₂ transmitted from the third battery cell 120-3 to the second battery cell 120-2 may be transferred to the second battery cell 120-2. The signal S₃₂ transmitted from the third battery cell 120-3 to the second battery cell 120-2 may be changed into a signal S₂₁ transmitted from the second battery cell 120-2 to the first battery cell 120-1 after being transmitted to the second battery cell 120-2. The signal S₂₁ transmitted from the second battery cell 120-2 to the first battery cell 120-1 may be changed into the signal S₁₀ transmitted from the first battery cell 120-1 to the master BMS 110 after being transmitted to the first battery cell 120-1. The master BMS 110 may receive the signal S₁₀ and obtain information on a state of the third battery cell included in the signal S₁₀.

When a signal passes through the battery cells 120 sequentially, the strength of the signal may be reduced by impedance (e.g., a resistance inside the battery cells) inside the battery cells 120. Since the strength of a signal decreases whenever the signal passes through the battery cells 120, if the signal is transmitted through the plurality of battery cells 120, it is necessary to maintain the strength of the signal. In addition, since a collision of the signal may occur when the signal is transmitted in a different direction, it is necessary to set a transmission directionality of the signal.

FIG. 3 illustrates an example of a first battery cell constituting a battery module according to an embodiment. Hereinafter, components described with respect to a first battery cell 120-1 may be equally applied to another battery cell.

Referring to FIG. 3, the first battery cell 120-1 may include a secondary battery 121, a protection circuit 123, and a first cell controller 200-1.

According to an embodiment, the secondary battery 121 may store electrical energy. The secondary battery 121 is a secondary battery capable of charging electrical energy and discharging the charged electrical energy, and may include a negative electrode material, a positive electrode material, a separator, and an electrolyte. According to an embodiment, the first battery cell 120-1 may include at least one secondary battery 121.

According to an embodiment, a protection circuit module (PCM) 123 is a protection circuit of the secondary battery 121 capable of preventing over-discharge, over-charge, and overcurrent of the secondary battery 121. The over-charge of the secondary battery 121 may cause internal overheating and swelling, thereby damaging the secondary battery 121. The over-discharge of the secondary battery 121 may damage the electrode and cause a failure of the secondary battery 121. To prevent damage and/or failure of the secondary battery 121, the protection circuit 123 may block a charge circuit based on identifying that a voltage of the secondary battery 121 has reached a charging limit voltage, and may block a discharge circuit based on identifying that a voltage of the secondary battery 121 has reached a discharge limit voltage. According to an embodiment, the protection circuit 123 may obtain information on a state of the secondary battery 121 and provide the obtained information to the first cell controller 200-1.

According to an embodiment, the first cell controller 200-1 may be configured to receive a signal from the master BMS 110 or transmit a signal from the master BMS 110, by being connected between the protection circuit 123 and the secondary battery 121. For example, the first cell controller 200-1 may be connected to a power line in the first battery cell 120-1, but is not limited thereto.

According to an embodiment, the first cell controller 200-1 may obtain information on a state of the secondary battery 121 from the protection circuit 123. For example, the information on the state of the secondary battery 121 may include information on voltage, current, and temperature of the secondary battery 121, but is not limited thereto. The first cell controller 200-1 may be electrically coupled to the protection circuit 123, and may receive the information on the state of the secondary battery 121 from the protection circuit 123. The first cell controller 200-1 may be configured to transmit the received information on the state of the secondary battery 121 to the master BMS 110.

According to an embodiment, the first cell controller 200-1 may receive a signal from the master BMS 110 via a bus bar (e.g., a bus bar 500 of FIG. 6). When a signal is received from the master BMS 110 to the first cell controller 200-1, the signal is transmitted through a plurality of battery cells (e.g., the plurality of first battery cells 120-1 of FIG. 1) connected to each other, thereby reducing a strength of the signal. For example, when a signal is transmitted from the master BMS 110 to the third battery cell 120-3, the signal may be transmitted to the third battery cell 120-3 by passing through the first battery cell 120-1 and the second battery cell 120-2. When a signal is transmitted, the strength of the signal may decrease due to the impedance inside the first battery cell 120-1 and the impedance inside the second battery cell 120-2.

According to an embodiment, the first cell controller 200-1 may identify whether a target of the signal received from the master BMS 110 is the first battery cell 120-1. The signal may include information on a target ID, which is information on an ID of the first battery cell 120-1, which is to be a reception target of the signal. The first cell controller 200-1 may compare the target ID included in the signal received from the master BMS 110 with an ID assigned to the first battery cell 120-1. The first cell controller 200-1 may perform an operation corresponding to the signal, based on identifying that the target ID corresponds to the ID assigned to the first battery cell 120-1. Based on identifying that the target ID does not correspond to the ID assigned to the first battery cell 120-1, the first cell controller 200-1 may be configured to amplify the signal and then transmit the amplified signal to a second battery cell (e.g., the second battery cell 120-2 of FIG. 1) connected to the first battery cell 120-1.

For example, when a signal requesting information on a state of the first battery cell 120-1 is transmitted from the master BMS 110 to the first battery cell 120-1, the first cell controller 200-1 of the first battery cell 120-1 connected in series to the master BMS 110 may receive the signal. The signal may include information on a target ID set as an ID assigned to the first battery cell 120-1. The first cell controller 200-1 of the first battery cell 120-1 may identify a target ID included in the received signal, and identify whether the identified target ID corresponds to an ID assigned to the first battery cell 120-1. In case of identifying that the identified target ID corresponds to an ID assigned to the first battery cell 120-1, the first cell controller 200-1 may be configured to generate a signal including information on a state of the first battery cell 120-1 and transmit the generated signal to the master BMS 110.

For example, when a signal requesting information on a state of the second battery cell 120-2 is transmitted from the master BMS 110 to the second battery cell 120-2, the first cell controller 200-1 of the first battery cell 120-1 connected in series to the master BMS 110 may receive the signal. The first cell controller 200-1 of the first battery cell 120-1 may identify a target ID included in the received signal, and identify whether the identified target ID corresponds to an ID assigned to the first battery cell 120-1. In case of identifying that the identified target ID does not correspond to the ID assigned to the first battery cell 120-1, the first cell controller 200-1 may amplify the signal and then transmit the amplified signal to the second battery cell 120-2 connected in series to the first battery cell 120-1. Based on identifying that the target ID included in the signal corresponds to an ID assigned to the second battery cell 120-2, the second cell controller (e.g., the second cell controller 200-2 of FIG. 1) of the second battery cell 120-2 may generate a signal including information on a state of the second battery cell 120-2. The second cell controller 200-2 may be configured to transmit the generated signal to the master BMS 110.

Referring to FIG. 3, the first cell controller 200-1 may include a microprocessor 201 that controls transmission and/or reception of signals, an amplification circuit 202 for amplifying a signal transmitted to and/or received from the microprocessor 201, and a switch SW for controlling a transmission path of signals.

According to an embodiment, a signal transmitted to and/or received from the first cell controller 200-1 may be amplified through the amplification circuit 202 and then transmitted and/or received. When a signal is received from the outside of the first cell controller 200-1, the switch SW may provide a reception path of the signal by being closed so that the signal is received by the microprocessor 201. When a signal is transmitted from the first cell controller 200-1, the switch SW may provide a transmission path of the signal by being closed so that the signal is transmitted from the microprocessor 201.

According to an embodiment, the first cell controller 200-1 may be connected between the protection circuit 123 and the secondary battery 121. Referring to FIG. 3, the first cell controller 200-1 may include a first terminal 125a connected to a positive electrode tab 121a of the secondary battery 121 and a first terminal 123a of the protection circuit 123, and a second terminal 125b connected to a negative electrode tab 121b of the secondary battery 121 and a second terminal 123b of the protection circuit 123. A signal transmitted to the first battery cell 120-1 may be transmitted to the first cell controller 200-1 through the first end 125a of the first cell controller 200-1. The first cell controller 200-1 may identify a signal received from the master BMS 110 based on a potential difference V₂-V₁ between the second end 125b of the first cell controller 200-1 and the first end 125a of the first cell controller 200-1. For example, the first cell controller 200-1 may detect potential V₂ of the second end 125b of the first cell controller 200-1 and potential V₁ of the first end 125a of the first cell controller 200-1, identify a signal by the potential difference V₂-V₁, and receive and/or transmit the signal.

According to an embodiment, when a target ID included in the received signal does not correspond to an ID assigned to the first battery cell 120-1, the first cell controller 200-1 may apply the amplified signal to the first end 125a of the first cell controller 200-1 to transmit the signal to the second battery cell 120-2. The amplified signal applied to the first end 125a of the first cell controller 200-1 may be transmitted to the second battery cell 120-2 through the secondary battery 121. Therefore, even when the signal passes through the first battery cell 120-1, it is amplified at the first end 125a of the first cell controller 200-1, and thus the signal may maintain a certain strength while passing through the plurality of battery cells 120 connected to each other.

According to an embodiment, the battery module 100 may maintain the strength of the signal using the plurality of cell controllers 200 by the plurality of battery cells 120 connected to each other, while simplifying a transmission and/or reception structure of a communication signal between the battery cells and ensuring the stability of power supply.

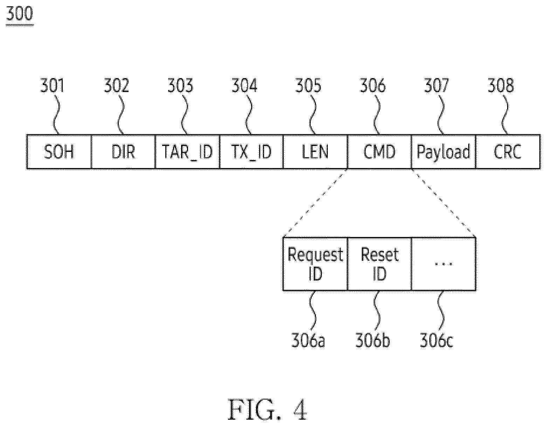

FIG. 4 illustrates an example of a data packet of a signal transmitted and received through a cell controller of a battery module according to an embodiment.

According to an embodiment, a signal transmitted and received through a plurality of cell controllers 200 of a battery module (e.g., the battery module 100 of FIG. 1) may include information for setting a directionality. Referring to FIG. 4, a data packet 300 of the signal may include information on a start of header (SOH) 301, a transmission direction of signal (DIR) 302, a target ID (TAR_ID) 303, a transmit ID (TX_ID) 304, a length of string (LEN) 305, a command indicating the command of actual operation (CMD) 306, a payload 307 that is data to be transmitted, and a cyclic redundancy check (CRC) 308 for checking errors. For example, in case that the DIR 302 is 0, a transmission direction of a signal may be the first direction of FIG. 1 (e.g., the first direction D1 of FIG. 1), and in case that the DIR 302 is 1, the transmission direction of the signal may be the second direction of FIG. 1 (e.g., the second direction D2 of FIG. 1). However, it is not limited thereto. The TX_ID 304 indicates an ID assigned to a battery management system (e.g., the master BMS 110 of FIG. 1) transmitting the corresponding signal, or a plurality of battery cells (e.g., the plurality of battery cells 120 of FIG. 1). The TAR_ID 303 may indicate an ID assigned to the master BMS 110 that will receive the corresponding signal, or the plurality of battery cells 120.

According to an embodiment, the CMD 306 included in the data packet 300 may include information related to a specific operation. Referring to FIG. 4, the CMD 306 may include a packet 306a including information for requesting the assignment of an ID for each of the plurality of battery cells 120, and a packet 306b including information for requesting the reset of an ID preassigned to the plurality of battery cells 120. For example, the plurality of battery cells 120 may transmit a data signal in which 1 is inputted to the packet 306a to the master BMS 110 in order to request ID assignment. The CMD 306 may include a packet 306c including various information, in addition to the above-described packets 306a and 206b. For example, the master BMS 110 may transmit, to the first battery cell 120-1, a data signal including information requesting information on a state of a first battery cell (e.g., the first battery cell 120-1 of FIG. 1). The first battery cell 120-1 may transmit information on the state of the first battery cell 120-1 to the master BMS 110, based on receiving the data signal.

According to an embodiment, when a signal is transmitted to any one battery cell of the plurality of battery cells 120, a cell controller among the plurality of cell controllers (e.g., the plurality of cell controllers 200 of FIG. 1), which is disposed in the any one battery cell, may compare the DIR 302 with an ID assigned to the any one of the battery cells.

For example, when the DIR 302 is 0, an ID assigned to the second battery cell 120-2 does not match TAR_ID 303, and a battery cell with an ID corresponding to the TAR_ID 303 is located in a first direction D1 than a battery cell with an ID corresponding to TX_ID 304, the second cell controller 200-2 may ignore the received signal. Since the above-described example is a case in which a signal is incorrectly transmitted in a direction opposite to the transmission direction of the signal, the second cell controller 200-2 may ignore the received signal.

For example, when the DIR 302 is 1, an ID assigned to the second battery cell 120-2 does not match TAR_ID 303, and a battery cell with an ID corresponding to the TAR_ID 303 is located in a second direction D2 than a battery cell with an ID corresponding to TX_ID 304, the second cell controller 200-2 may transmit a signal in the second direction D2. As described above, the second cell controller 200-2 may amplify and then transmit a signal. In the above example, since the signal is transmitted in the transmission direction of the signal, the second cell controller 200-2 may amplify and then transmit the received signal in the second direction D2, so that the signal may be transmitted up to a battery cell with an ID matching the TAR_ID 303. The signal may be sequentially transmitted, and then transmitted up to a battery cell where the TAR_ID 303 and the ID match, and an operation corresponding to the signal may be performed in the corresponding battery cell.

For example, when an ID assigned to the second battery cell 120-2 matches the TAR_ID 303, the second cell controller 200-2 may perform a designated operation based on CMD 306 included in the data packet 300 of the signal.

According to an embodiment, in the battery module 100 including the plurality of battery cells 120 connected to each other, signal transmission and reception between the master BMS 110 and the plurality of battery cells 120 may be smoothly performed. Through a signal including information on a signal transmission direction and a target ID, the battery module 100 according to an embodiment may prevent collision of the signal due to a serial connection.

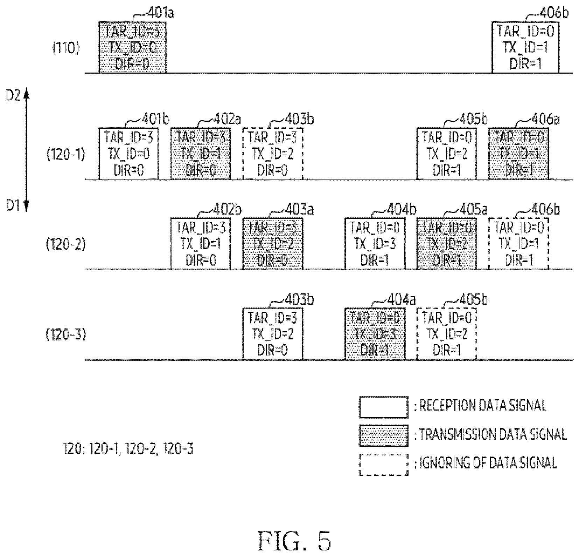

FIG. 5 illustrates an example of an operation of transmitting and receiving a data signal of a plurality of battery cells of a battery module according to an embodiment.

The operation illustrated in FIG. 5 is performed assuming that IDs are sequentially assigned to a plurality of battery cells 120 connected in series to the master BMS 110. In the operation illustrated in FIG. 5, it is assumed that an ID assigned to the master BMS 110 is 0 (ID=0), an ID assigned to the first battery cell 120-1 is 1 (ID=1), an ID assigned to the second battery cell 120-2 is 2 (ID=2), and an ID assigned to the third battery cell 120-3 is 3 (ID=3).

Referring to FIG. 5, in order to transmit a data signal to the third battery cell 120-3, the master BMS 110 may generate a data signal 401a and transmit the generated data signal 401a to the first battery cell 120-1. The data signal 401a may include information on a target ID, information on a transmission ID, and information on a transmission direction. Referring to FIG. 5, the data signal 401a may include information in which the target ID is 3, the transmission ID is 0, and the transmission direction is a first direction D1.

According to an embodiment, the first battery cell 120-1 may receive a data signal 401b from the master BMS 110. A first cell controller (e.g., the first cell controller 200-1 of FIG. 1) of the first battery cell 120-1 may identify information on a target ID included in the data signal 401b and compare it with an ID assigned to the first battery cell 120-1. Since the information on the target ID included in the data signal 401b is 3, the first cell controller 200-1 of the first battery cell 120-1 may identify that the target ID does not correspond to the ID assigned to the first battery cell 120-1, and transmit a data signal 402a to the second battery cell 120-2. The data signal 402a may include information in which the target ID is 3, the transmission ID is 1, and the transmission direction is the first direction D1.

According to an embodiment, the second battery cell 120-2 may receive the data signal 402b from the first battery cell 120-1. A second cell controller (e.g., the second cell controller 200-2 of FIG. 1) of the second battery cell 120-2 may identify information on a target ID included in the data signal 402b and compare it with an ID assigned to the second battery cell 120-2. Since the information on the target ID included in the data signal 402b is 3, the second cell controller 200-2 of the second battery cell 120-2 may identify that the target ID does not correspond to the ID assigned to the second battery cell 120-2, and transmit a data signal 403a to the third battery cell 120-3. The data signal 403a may include information in which the target ID is 3, the transmission ID is 2, and the transmission direction is the first direction D1.

According to an embodiment, the third battery cell 120-3 may receive the data signal 403b from the second battery cell 120-2. A third cell controller (e.g., the third cell controller 200-3 of FIG. 1) of the third battery cell 120-3 may identify information on a target ID included in the data signal 403b and compare it with an ID assigned to the third battery cell 120-3. Since the information on the target ID included in the data signal 403b is 3, the third cell controller 200-3 of the third battery cell 120-3 may identify that the target ID corresponds to the ID assigned to the third battery cell 120-3, and perform an operation corresponding to the data signal 403b.

According to an embodiment, when the first battery cell 120-1 receives the data signal 403b from the second battery cell 120-2, the first cell controller 200-1 may check information included in the data signal 403b. Since the transmission ID included in the data signal 403b is 2 and the transmission direction is the first direction D1, the first cell controller 200-1 of the first battery cell 120-1 may ignore the data signal 403b.

According to an embodiment, the third battery cell 120-3 may perform an operation corresponding to the information included in the data signal 403b. When the information included in the data signal 403b includes a request for information on a state of the third battery cell 120-3, the third battery cell 120-3 may transmit a data signal 404a including the information on the state of the third battery cell 120-3 to the second battery cell 120-2. The data signal 404a may include information on a target ID, information on a transmission ID, and information on a transmission direction. Referring to FIG. 5, the data signal 404a may include information in which the target ID is 0, the transmission ID is 3, and the transmission direction is the second direction D2.

According to an embodiment, the second battery cell 120-2 may receive a data signal 404b from the third battery cell 120-3. The second cell controller 200-2 of the second battery cell 120-2 may identify information on a target ID included in the data signal 404b and compare it information with an ID assigned to the second battery cell 120-2. Since the information on the target ID included in the data signal 404b is 0, the second cell controller 200-2 of the second battery cell 120-2 may identify that the target ID does not correspond to the ID assigned to the second battery cell 120-2 and transmit a data signal 405a to the first battery cell 120-1. The data signal 405a may include information in which the target ID is 0, the transmission ID is 2, and the transmission direction is the second direction D2.

According to an embodiment, the first battery cell 120-1 may receive a data signal 405b from the second battery cell 120-2. The first cell controller 200-1 of the first battery cell 120-1 may identify information on a target ID included in the data signal 405b and compare it with an ID assigned to the first battery cell 120-1. Since the information on the target ID included in the data signal 405b is 0, the first cell controller 200-1 of the first battery cell 120-1 may identify that the target ID does not correspond to the ID assigned to the first battery cell 120-1 and transmit a data signal 406a to the master BMS 110. The data signal 406a may include information in which the target ID is 0, the transmission ID is 1, and the transmission direction is the second direction D2.

According to an embodiment, when the third battery cell 120-3 receives the data signal 405b from the second battery cell 120-2, the third cell controller 200-3 of the third battery cell 120-3 may check information included in the data signal 405b. Since the transmission ID included in the data signal 405b is 2 and the transmission direction is the second direction D2, the third cell controller 200-3 of the third battery cell 120-3 may ignore the data signal 405b.

According to an embodiment, the master BMS 110 may receive a data signal 406b from the first battery cell 120-1. The master BMS 110 may identify information on a target ID included in the data signal 406b and compare it with an ID assigned to the master BMS 110. Since the information on the target ID included in the data signal 406b is 0, the master BMS 110 may identify that the target ID corresponds to the ID assigned to the master BMS 110. The master BMS 110 may receive the data signal 406b.

According to an embodiment, when the second battery cell 120-2 receives the data signal 406b from the first battery cell 120-1, the second cell controller 200-2 of the second battery cell 120-2 may check information included in the data signal 406b. Since the transmission ID included in the data signal 406b is 1 and the transmission direction is the second direction D2, the second cell controller 200-2 of the second battery cell 120-2 may ignore the data signal 406b.

As described above, a signal transmission structure of a plurality of battery cells 120 connected to the master BMS 110 may be simply performed through a plurality of cell controllers (e.g., the plurality of cell controllers 200 of FIG. 1). According to an embodiment, information included in a transmitted and received signal may prevent errors in signal transmission and improve accuracy.

FIG. 6 illustrates an example of a battery module according to an embodiment. FIG. 7 illustrates an example of a switch of a battery module according to an embodiment.

Referring to FIG. 6, a battery module 100 according to an embodiment may include a plurality of battery cells 120, a master battery management system 110, a bus bar 500, and a switch 600.

The battery module 100 according to an embodiment may include a master BMS 110 for managing the plurality of battery cells 120. The plurality of battery cells 120 and the master BMS 110 may be referred to as the plurality of battery cells 120 and the master BMS 110 described above. Since the contents described with reference to FIGS. 1 to 5 may be equally applied to a battery module 100 to be described below, a redundant description thereof will be omitted.

According to an embodiment, the bus bar 500 may connect the plurality of battery cells 120. For example, when the plurality of battery cells 120 are connected in series, the bus bar 500 may connect a positive terminal of a battery cell and a negative terminal of another battery cell. The busbar 500 illustrated in FIG. 6 is illustrated in a portion of a connection line between the plurality of battery cells 120, but may be disposed over the entire connection line between the plurality of battery cells 120. The bus bar 500 may be electrically connected to the master BMS 110. For example, the master BMS 110 and at least a portion of the plurality of battery cells 120 may be connected to each other via the bus bar 500. However, it is not limited thereto.

According to an embodiment, the master BMS 110 may be configured to communicate with the plurality of battery cells 120 via the bus bar 500. The master BMS 110 may transmit a signal to the plurality of cell controllers 200 via the bus bar 500, and the plurality of cell controllers 200 may transmit a signal to the master BMS 110 via the bus bar 500. For example, when the master BMS 110 transmits a signal to the second battery cell 120-2, the signal may be transmitted to the second battery cell 120-2 via the bus bar 500.

As illustrated in FIG. 1, when the first battery cell 120-1 and the second battery cell 120-2 are connected in series, the signal may be transmitted to the second battery cell 120-2 by passing through the first battery cell 120-1. The signal may include information (e.g., TAR_ID 303 of FIG. 3) on an ID assigned to the second battery cell 120-2 that will receive a signal. The first cell controller 200-1 may identify the information, amplify the received signal, and then transmit int to the second battery cell 120-2.

As illustrated in FIG. 6, when the first battery cell 120-1 and the second battery cell 120-2 are connected to each other in parallel, the signal may be directly transmitted from the master BMS 110 to the second battery cell 120-2. However, it is not limited thereto. Since a transmission and/or reception operation of the signal may be referred to as the operations described with reference to FIGS. 1 to 5, a redundant description thereof will be omitted.

According to an embodiment, the switch 600 may be configured to electrically connect or electrically disconnect any one of the plurality of battery cells 120 with remaining battery cells. According to an embodiment, the switch 600 may electrically connect or electrically disconnect the first battery cell 120-1 and the second battery cell 120-2.

Referring to FIG. 7, the switch 600 may include a first switch 600-1 connected to both ends of the first battery cell 120-1, a second switch 600-2, a third switch 600-3 connected to both ends of the second battery cell 120-2, a fourth switch 600-4, a fifth switch 600-5 connected to both ends of the third battery cell 120-3, and a sixth switch 600-6. For example, when the first switch 600-1 and the second switch 600-2 are opened, the first battery cell 120-1 may be electrically disconnected from the second battery cell 120-2 and the third battery cell 120-3. For example, when the first switch 600-1 and the second switch 600-2 are closed, the first battery cell 120-1 may be electrically connected with the second battery cell 120-2 and the third battery cell 120-3. Even when the first battery cell 120-1 is electrically disconnected from the second battery cell 120-2 and the third battery cell 120-3, the second battery cell 120-2 and the third battery cell 120-3 may be configured to supply power to a load. However, the shape or the arranged position of the switch 600 is not limited as illustrated in the drawing. The switch 600 may be disposed outside the battery cell or may be disposed inside the battery cell.

According to an embodiment, the switch 600 may be controlled by the master BMS 110 and/or the plurality of cell controllers 200. For example, the first cell controller 200-1 disposed in the first battery cell 120-1 may be configured to control the first switch 600-1 and the second switch 600-2, which are disposed at both ends of the first battery cell 120-1. The first cell controller 200-1 may control the first switch 600-1 and the second switch 600-2 to be opened or closed

According to an embodiment, the master BMS 110 may directly and/or indirectly control the switch 600. For example, the master BMS 110 may directly transmit a signal for controlling an operation of the switch 600 to the switch 600. For example, the master BMS 110 may transmit the signal for controlling an operation of the switch 600 to the first cell controller 200-1, among the plurality of cell controllers 200. The first cell controller 200-1 receiving the signal may be configured to control the first switch 600-1 and the second switch 600-2 based on the signal.

According to an embodiment, each of the plurality of cell controllers 200 may be configured to obtain data related to a deterioration of the plurality of battery cells 120. The data related to the deterioration of the plurality of battery cells 120 may refer to various data quantitatively indicating a degree of a state of health (SOH) of a battery. According to an embodiment, the first cell controller 200-1 may be configured to obtain data on at least one of changes in a state of charge (SOC) according to voltage, current, temperature, charging and/or discharging of the first battery cell 120-1. For example, when the first battery cell 120-1 is charged, the first cell controller 200-1 may identify a change in the state of charge (SOC) of the first battery cell 120-1. The first cell controller 200-1 may obtain data including information on a change in SOC of a battery cell over time. For example, the first cell controller 200-1 may identify a change in SOC of the first battery cell 120-1 when the first battery cell 120-1 is discharged. The first cell controller 200-1 may obtain data including information on a change in SOC of a battery cell over time. For example, the first cell controller 200-1 may identify a temperature of the first battery cell 120-1 when the first battery cell 120-1 operates. The first cell controller 200-1 may obtain data including information on a temperature change of the first battery cell 120-1 according to an operation time.

According to an embodiment, when it is determined that the first battery cell 120-1 is deteriorated, the first battery cell 120-1 may be electrically disconnected from other battery cells. The determination of the deterioration of the first battery cell 120-1 may be performed by the master BMS 110 and/or the first cell controller 200-1, but is not limited thereto.

According to an embodiment, when it is determined that the first battery cell 120-1 is deteriorated, the first cell controller 200-1 may be configured to control the switch 600 to electrically disconnect the first battery cell 120-1 from the second battery cell 120-2. In case that the first battery cell 120-1 is deteriorated, when the battery module 100 including the first battery cell 120-1 is operated, a performance of the battery module 100 may be deteriorated by the first battery cell 120-1. For example, when the battery module 100 is charged, in case that a voltage of the deteriorated first battery cell 120-1 is lower than a voltage in a normal state, a voltage of the second battery cell 120-2 may be lowered according to the voltage of the first battery cell 120-1 by cell balancing. In the above-described case, since the voltage of the second battery cell 120-2 in a normal state is consumed, energy efficiency may be lowered. For example, when the battery module 100 is operated, in case that a temperature of the deteriorated first battery cell 120-1 is higher than a temperature in a normal state, a temperature of the battery module 100 may be increased by the first battery cell 120-1. As the temperature of the battery module 100 is increased, a fire may occur or an operation of a device (e.g., electric vehicle) using the battery module 100 may be stopped according to a safety system of the device.

According to an embodiment, the master BMS 110 and/or the first cell controller 200-1 may determine the deterioration of the first battery cell 120-1, based on data related to the deterioration of the first battery cell 120-1. When it is determined that the first battery cell 120-1 is deteriorated, the first cell controller 200-1 may electrically disconnect the first battery cell 120-1 from other battery cells by controlling the switch 600. As the deteriorated first battery cell 120-1 is disconnected, a performance degradation of the battery module 100 may be prevented.

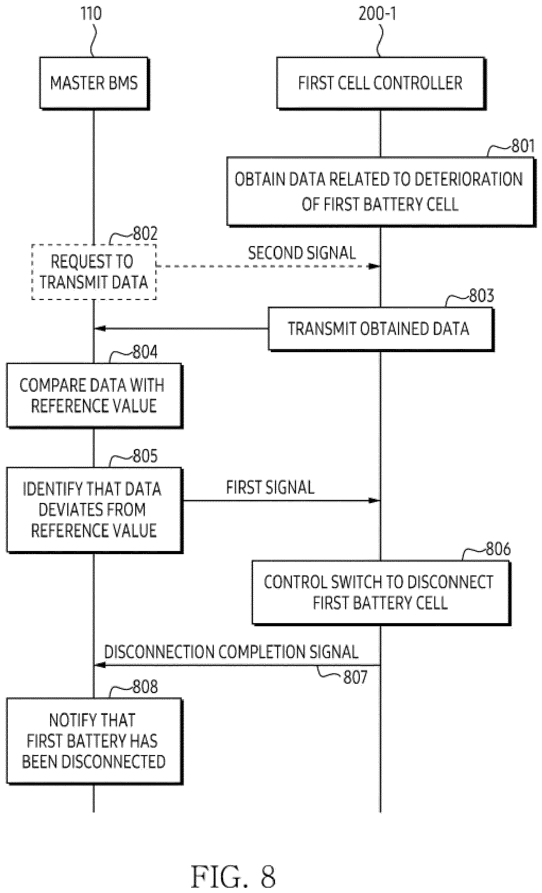

FIG. 8 is a flowchart illustrating an example of an operation for separating a battery cell in which a master BMS of a battery module is deteriorated, according to an embodiment. The operations of a first cell controller (e.g., the first cell controller 200-1 of FIG. 6) described with reference to FIG. 8 may be equally applied to cell controllers (e.g., the second cell controller 200-2) of remaining battery cells.

In operation 801, the first cell controller 200-1 may be configured to obtain data related to the deterioration of the first battery cell 120-1. For example, the first cell controller 200-1 may be configured to obtain data on at least one of SOC change according to voltage, current, temperature, charging and/or discharge of the first battery cell 120-1. The data related to deterioration may refer to data indicating a degree of SOH of the first battery cell 120-1. The first cell controller 200-1 may be configured to obtain the data, independently of whether the first battery cell 120-1 is activated. For example, in a state that the first battery cell 120-1 is activated, the first cell controller 200-1 may be configured to measure temperature, operating voltage, and/or operating current of the first battery cell 120-1, and obtain data related to the measured temperature, operating voltage and/or operating current. For example, in a state that the first battery cell 120-1 is in an inactivated state (e.g., a sleep state or a turn-off state), the first cell controller 200-1 may be configured to measure an open voltage of the first battery cell 120-1 and obtain data related to the measured open voltage. The above-described data is merely exemplary and is not limited thereto.

In operation 802, the master BMS 110 may be configured to request the first cell controller 200-1 to transmit the obtained data. For example, in operation 802, the master BMS 110 may transmit a second signal requesting the first cell controller 200-1 to transmit the obtained data. The second signal may be transmitted from the master BMS 110 to the first cell controller 200-1 through a bus bar (e.g., the bus bar 500 of FIG. 6). For example, the master BMS 110 may transmit the second signal to the first cell controller 200-1 every cycle designated by the user. For example, the master BMS 110 may transmit the second signal to the first cell controller 200-1 when a specified event occurs.

According to an embodiment, operation 802 may be omitted. In case that operation 802 is omitted, the first cell controller 200-1 may perform operation 803 even when there is no separate request from the master BMS 110. According to an embodiment, operation 802 may be performed based on a state of the first battery cell 120-1. According to an embodiment, in a first state in which the first battery cell 120-1 operates, the first cell controller 200-1 may transmit the obtained data to the master BMS 110 via the bus bar 500 without receiving a separate request signal from the master BMS 110. The first state may mean a state in which the first battery cell 120-1 supplies power to a load. In the first state, the first cell controller 200-1 may be configured to transmit the obtained data to the master BMS 110. According to an embodiment, operation 802 may be performed in a second state distinct from the first state. The second state may mean a turn-off state, a low power operation state, or a sleep state in which the first battery cell 120-1 does not supply power to a load. In the second state of the first battery cell 120-1, the master BMS 110 may be configured to transmit a second signal for requesting transmission of the data to the first cell controller 200-1. Since power consumption of the first battery cell 120-1 may need to be minimized in the second state, the first cell controller 200-1 may be configured to transmit the data to the master BMS 110 when the second signal is received. For example, in case that the first cell controller 200-1 continuously performs transmitting data to the master BMS 110 in a situation where the driving power for the load is insufficient, a situation in which the load cannot be driven due to the lack of power may occur. The first cell controller 200-1 may minimize power consumption of the first battery cell 120-1 due to the data transmission.

In operation 803, the first cell controller 200-1 may be configured to transmit the obtained data related to the deterioration of the first battery cell 120-1 to the master BMS 110. For example, the first cell controller 200-1 may transmit the obtained data to the master BMS 110 based on receiving a signal requesting a transmission of the data from the master BMS 110. For example, the first cell controller 200-1 may transmit the obtained data to the master BMS 110 every cycle designated by the user. For example, when a specified event occurs, the first cell controller 200-1 may transmit the obtained data to the master BMS 110.

In operation 804, the master BMS 110 may be configured to compare the data obtained from the first cell controller 200-1 with a predetermined reference value. The predetermined reference value may be a value indicating a normal state in which the first battery cell 120-1 is not deteriorated. The predetermined reference value may be determined as a range in which the deterioration of the first battery cell 120-1 may be determined based on the type of data. For example, in case that the first cell controller 200-1 transmits data including information on a temperature of the first battery cell 120-1, the predetermined reference value may be determined as a temperature range of the first battery cell 120-1 in a normal state. The temperature range of the first battery cell 120-1 in a normal state may mean a range of a temperature at which the first battery cell 120-1 can operate normally. For example, in case that the first cell controller 200-1 transmits data on SOC when the first battery cell 120-1 is charged, the predetermined reference value may be determined as a rate of change of SOC over time of the first battery cell 120-1 in a normal state.

In operation 805, based on identifying that the data received from the first cell controller 200-1 deviates from a reference value, as a result of the comparison in operation 804, the master BMS 110 may be configured to transmit a first signal for separating the first battery cell 120-1 from the second battery cell 120-2 to the first cell controller 200-1. For example, the master BMS 110 may transmit the first signal to the first cell controller 200-1 when it is identified that data including information on the temperature of the first battery cell 120-1 received from the first cell controller 200-1 is not included in the reference value. The first signal may be transmitted from the master BMS 110 to the first cell controller 200-1 via the bus bar 500.

In operation 806, the first cell controller 200-1 may be configured to control the switch 600 to electrically disconnect the first battery cell 120-1 from the second battery cell 120-2, based on receiving the first signal from the master BMS 110. For example, the first cell controller 200-1 may control the first switch 600-1 (e.g., the first switch 600-1 of FIG. 7) and the second switch 600-2 (e.g., the second switch 600-2 of FIG. 7) to be opened, based on receiving the first signal. The first battery cell 120-1 being electrically disconnected from the second battery cell 120-2 may mean that the first battery cell 120-1 is electrically disconnected from other battery cells except for the first battery cell 120-1 in the battery module 100. Even when the first battery cell 120-1 is electrically disconnected from the remaining battery cells, the first battery cell 120-1 may maintain an electrical connection with the master BMS 110. The master BMS 110 may continuously manage the SOH of the separated first battery cell 120-1. In operation 805 and operation 806, it is described that the switch 600 is being controlled by the first cell controller 200-1, but is not limited thereto. For example, the master BMS 110 may electrically disconnect the first battery cell 120-1 from the second battery cell 120-2, by directly controlling the switch 600, based on identifying that the data received from the first cell controller 200-1 deviates from a reference value.

In operation 807, the first cell controller 200-1 may be configured to transmit, to the master BMS 110, a signal for notifying that the first battery cell 120-1 has been electrically disconnected from the second battery cell 120-2. The first cell controller 200-1 may control the switch 600 and then transmit the signal to the master BMS 110. The signal may be transmitted from the first cell controller 200-1 to the master BMS 110 via the bus bar 500.

In operation 808, the master BMS 110 may be configured to notify that the first battery cell 120-1 has been electrically disconnected from the second battery cell 120-2. For example, the master BMS 110, which is a component of a device including the battery module 100, may transmit a signal indicating that the first battery cell 120-1 has been disconnected. For example, in an electric vehicle including the battery module 100, the master BMS 110 may transmit, to the user, a visual or audible signal to notify that the first battery cell 120-1 has been disconnected, through a display or speaker. Through the notification, the user may recognize that the first battery cell 120-1 has deteriorated.

The battery module 100 according to an embodiment may identify whether each of the plurality of battery cells 120 is deteriorated through the plurality of cell controllers 200 disposed in the plurality of battery cells 120 electrically connected to each other. In general, in order to identify a deterioration of a battery cell, a separate process, such as charging and discharging a battery cell through a deterioration determination device, is required. The battery module 100 according to an embodiment may easily obtain data related to deterioration by the plurality of cell controllers 200 included in each of the plurality of battery cells 120. Since the obtained data may be transmitted to the master BMS 110 via the bus bar 500, a separate wire harness for communication is not required. Thus, the weight of the entire system may be lightened, and the design may be facilitated. The master BMS 110 may determine whether each of the plurality of battery cells 120 is deteriorated based on the received data. The master BMS 110 may prevent performance degradation of the battery module 100 due to the deteriorated battery cell, by electrically disconnecting the deteriorated battery cell from the remaining battery cells.

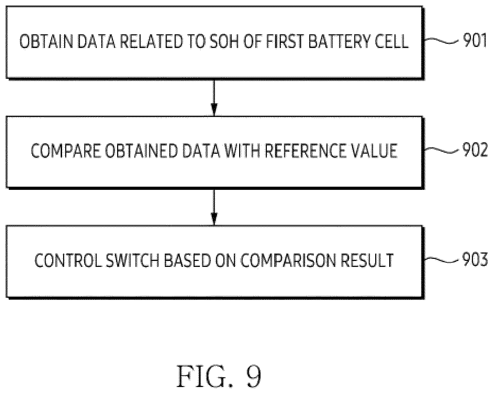

FIG. 9 is a flowchart illustrating an example of an operation in which a cell controller of a battery module separates a deteriorated battery cell, according to an embodiment. The operations of a first cell controller 200-1 described with reference to FIG. 9 may be equally applied to cell controllers (e.g., the second cell controller 200-2) of remaining battery cells.

Referring to FIG. 9, in operation 901, the first cell controller 200-1 may be configured to obtain data related to the deterioration of the first battery cell 120-1. For example, the first cell controller 200-1 may be configured to obtain data on at least one of changes in SOC according to voltage, current, temperature, charging and/or discharging of the first battery cell 120-1. The first cell controller 200-1 may be configured to obtain the data, independently of whether the first battery cell 120-1 is activated. For example, in a state that the first battery cell 120-1 is activated, the first cell controller 200-1 may be configured to measure a temperature, operating voltage, and/or operating current of the first battery cell 120-1, and obtain data related to the measured temperature, operating voltage and/or operating current. For example, in a state that the first battery cell 120-1 is in an inactivated state (e.g., a sleep state or a turn-off state), the first cell controller 200-1 may be configured to measure an open voltage of the first battery cell 120-1 and obtain data related to the measured open voltage. The above-described data is merely exemplary and is not limited thereto.

In operation 902, the first cell controller 200-1 may be configured to compare the obtained data with a predetermined reference value. The predetermined reference value may be determined as a range in which the deterioration of the first battery cell 120-1 may be determined based on the type of data. For example, in case that the first cell controller 200-1 obtains data including information on a temperature of the first battery cell 120-1, the predetermined reference value may be determined as a temperature range of the first battery cell 120-1 in a normal state. The temperature range of the first battery cell 120-1 in the normal state may mean a range of a temperature at which the first battery cell 120-1 can operate normally. For example, in case that the first cell controller 200-1 obtains data on the SOC when the first battery cell 120-1 is charged, the predetermined reference value may be determined as a rate of change of the SOC over time of the first battery cell 120-1 in the normal state.

In operation 903, the first cell controller 200-1 may be configured to control the switch 600 based on the comparison result in operation 902. According to an embodiment, the first cell controller 200-1 may be configured to control the switch 600 to electrically disconnect the first battery cell 120-1 from the second battery cell 120-2, based on identifying that the obtained data deviates from the reference value. The first controller may be configured to control the switch 600 such that the first battery cell 120-1 is electrically connected to the second battery cell 120-2, based on identifying that the obtained data is included within the reference value.

According to an embodiment, the first cell controller 200-1 may be configured to determine the deterioration of the first battery cell 120-1, based on data related to the deterioration of the first battery cell 120-1. Since the first cell controller 200-1 may determine the deterioration of the first battery cell 120-1 by itself, it may be determined whether to disconnect the first battery cell 120-1 without transmitting and/or receiving a signal with the master BMS 110.

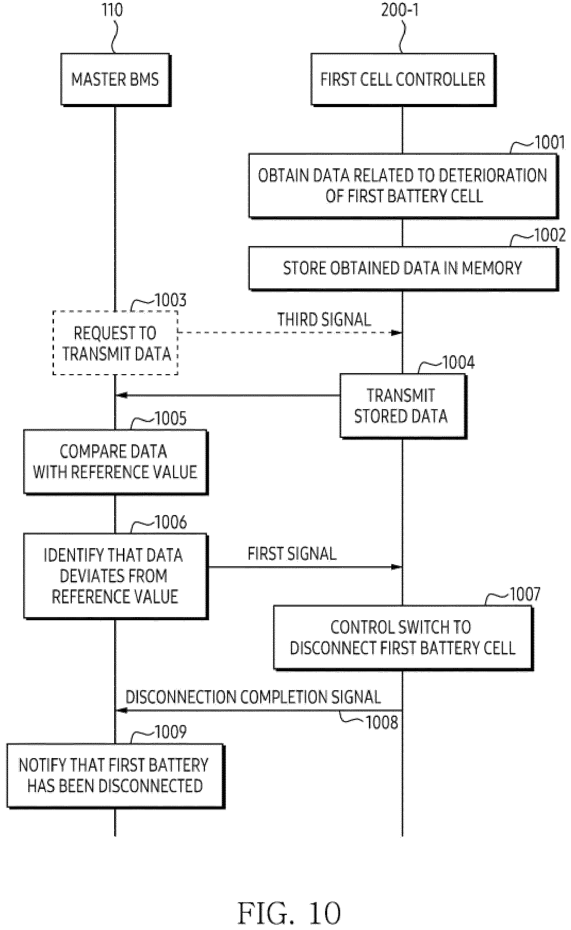

FIG. 10 is a flowchart illustrating an example of an operation in which a master BMS of a battery module separates a deteriorated battery cell based on data recorded in memory of a cell controller, according to an embodiment. The operations of the first cell controller 200-1 described with reference to FIG. 10 may be equally applied to cell controllers (e.g., the second cell controller 200-2) of remaining battery cells.

Referring to FIG. 10, in operation 1001, the first cell controller 200-1 may be configured to obtain data related to the deterioration of the first battery cell 120-1. Operation 1001 may be referred to as operation 801 of FIG. 8.

In operation 1002, the first cell controller 200-1 may be configured to store the obtained data in memory (e.g., the memory 250 of FIG. 2). The memory 250 may be configured to store data related to the deterioration of the first battery cell 120-1.

In operation 1003, the master BMS 110 may be configured to transmit a third signal requesting transmission of data recorded in the memory 250 to the first cell controller 200-1. The master BMS 110 may request the first cell controller 200-1 to transmit the data stored in the memory 250, in order to determine whether the first battery cell 120-1 is deteriorated. The third signal may be transmitted from the master BMS 110 to the first cell controller 200-1 via the bus bar 500.

In operation 1004, the first cell controller 200-1 may be configured to transmit at least a portion of the data stored in the memory 250 to the master BMS 110, based on receiving the third signal. The first cell controller 200-1 may transmit all of the data stored in the memory 250 to the master BMS 110, or may transmit some of the data stored in the memory 250 to the master BMS 110. For example, the master BMS 110 may transmit, to the first cell controller 200-1, the third signal including information requesting transmission of all or some of the data, according to the time after determining whether the first battery cell 120-1 is deteriorated and/or the number of times power is supplied from the first battery cell 120-1 to a load. The first cell controller 200-1 may transmit all or some of data to the master BMS 110, based on the third signal. For example, the first cell controller 200-1 may transmit data, which has never been transmitted to the master BMS 110 and is newly stored in the memory 250, to the master BMS 110, except for data transmitted to the master BMS 110 before receiving the third signal. However, it is not limited thereto.

In operation 1005, the master BMS 110 may be configured to compare the data obtained from the first cell controller 200-1 with a predetermined reference value. Operation 1005 may be referred to as operation 804 of FIG. 8.

In operation 1006, the master BMS 110 may be configured to transmit a first signal for disconnecting the first battery cell 120-1 from the second battery cell 120-2 to the first cell controller 200-1, based on identifying that the data received from the first cell controller 200-1 deviates from the reference value, as a result of the comparison in operation 1005. Operation 1006 may be referred to as operation 805 of FIG. 8.

In operation 1007, the first cell controller 200-1 may be configured to control the switch 600 to electrically disconnect the first battery cell 120-1 from the second battery cell 120-2, based on receiving the first signal from the master BMS 110.

In operation 1008, the first cell controller 200-1 may be configured to transmit, to the master BMS 110, a signal for notifying that the first battery cell 120-1 has been electrically disconnected from the second battery cell 120-2. Operation 1008 may be referred to as operation 807 of FIG. 8.

In operation 1009, the master BMS 110 may be configured to notify that the first battery cell 120-1 has been electrically disconnected from the second battery cell 120-2. Operation 1009 may be referred to as operation 808 of FIG. 8.

The battery module 100 according to an embodiment may continuously store data related to the deterioration in the plurality of cell controllers 200 disposed in each of the plurality of battery cells 120. The data stored in the memory 250 may be transmitted to the master BMS 110 according to a request from the master BMS 110. The master BMS 110 may determine whether each of the plurality of battery cells 120 is deteriorated, through the data stored in the memory 250. Since each of the plurality of cell controllers 200 is disposed in the plurality of battery cells 120, it may be easy to obtain data related to the deterioration of the battery cells. Each of the plurality of cell controllers 200 may obtain data from a battery cell that is in operation or not, and record the obtained data in the memory 250. Through the data recorded in the memory 250, the master BMS 110 may easily determine whether each of the plurality of battery cells 120 is deteriorated. For example, the master BMS 110 may check a change in time required to charge the battery 100% when charging the battery cell through data stored in the memory 250. Through data stored for a predetermined period, the master BMS 110 may be configured to accurately determine the deterioration of each of the plurality of battery cells 120.

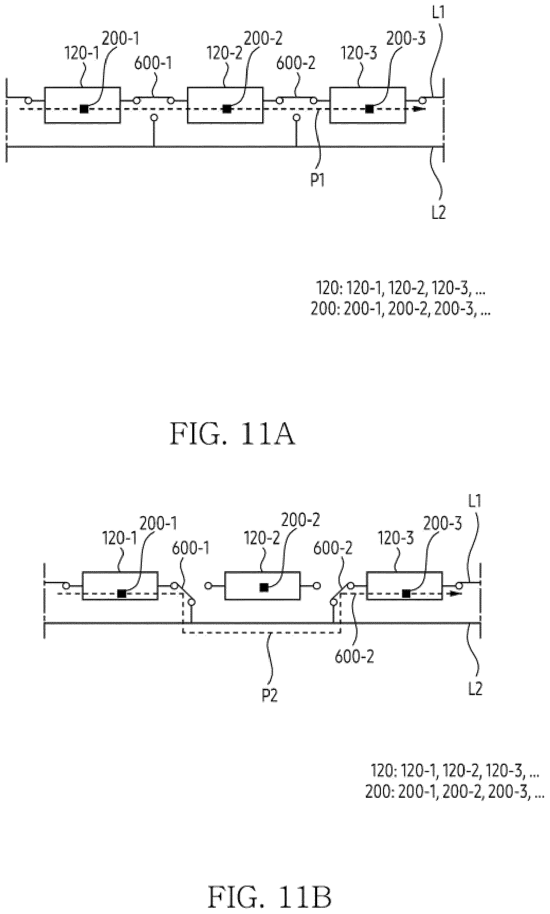

FIGS. 11A and 11B illustrate an example of a switch of a battery module according to an embodiment. Referring to FIGS. 11A and 11B, a switch 600 may include a first switch 600-1 and a second switch 600-2 connected to both ends of a second battery cell 120-2. A plurality of battery cells 120 may be connected in series to each other.

According to an embodiment, the battery module 100 may include a first line L1 to which all of the battery cells 120 are electrically connected and a second line L2 to which at least one of the battery cells 120 is electrically disconnected. The switch 600 may connect the plurality of battery cells 120 to the first line L1 or the second line L2.

Referring to FIG. 11A, in case that the first switch 600-1 and the second switch 600-2 are connected to the first line L1, the second battery cell 120-2 may be electrically connected to the first battery cell 120-1 and the third battery cell 120-3. The first battery cell 120-1, the second battery cell 120-2, and the third battery cell 120-3, which are electrically connected to each other, may be configured to supply power for driving a load. When the first switch 600-1 and the second switch 600-2 are connected to the first line L1, a path P1 of current flowing through the first battery cell 120-1, the second battery cell 120-2, and the third battery cell 120-3 may be formed.

Referring to FIG. 11B, when the first switch 600-1 and the second switch 600-2 are connected to the second line L2, the second battery cell 120-2 may be electrically disconnected from the first battery cell 120-1 and the third battery cell 120-3. The first battery cell 120-1 and the third battery cell 120-3 may be electrically connected to each other. When the first switch 600-1 and the second switch 600-2 are connected to the second line L2, a by-pass path P2 bypassing the second battery cell 120-2 may be formed. When the first switch 600-1 and the second switch 600-2 are connected to the second line L2, a path P2 of current flowing through the first battery cell 120-1 and the third battery cell 120-3 may be formed. Even when the second battery cell 120-2 is electrically disconnected from the first battery cell 120-1 and the third battery cell 120-3, the first battery cell 120-1 and the third battery cell 120-3 may be configured to supply power to a load through the path P2. However, the shape or the arranged position of the switch 600 is not limited as illustrated in the drawing. The switch 600 may be disposed outside the battery cell or may be disposed inside the battery cell.

According to an embodiment, the switch 600 may be controlled by a master BMS (e.g., the master BMS 110 of FIG. 6) and/or the plurality of cell controllers 200. For example, the first cell controller 200-1 disposed in the first battery cell 120-1 may be configured to control the first switch 600-1 and the second switch 600-2 disposed at both ends of the first battery cell 120-1. The first cell controller 200-1 may control the first switch 600-1 and the second switch 600-2 to be opened or closed

According to an embodiment, the master BMS 110 may directly and/or indirectly control the switch 600. For example, the master BMS 110 may directly transmit a signal for controlling an operation of the switch 600 to the switch 600. For example, the master BMS 110 may transmit a signal for controlling the operation of the switch 600 to the second cell controller 200-2 among the plurality of cell controllers 200. The second cell controller 200-2 receiving the signal may be configured to control the first switch 600-1 and the second switch 600-2, based on the signal.

According to an embodiment, each of the plurality of cell controllers 200 may be configured to obtain data related to the deterioration of the plurality of battery cells 120. The data related to the deterioration of the plurality of battery cells 120 may refer to various data quantitatively indicating a degree of a state of health (SOH) of a battery. A plurality of cell controllers 200 may identify a degree of deterioration of each of the plurality of battery cells 120 based on the data. The degree of deterioration may be a numerical value indicating how much the battery cell has deteriorated. The degree of deterioration may be identified, based on the data.

According to an embodiment, the master BMS 110 and/or the first cell controller 200-1 may determine the deterioration of the first battery cell 120-1 based on data related to the deterioration of the first battery cell 120-1. When it is determined that the first battery cell 120-1 is deteriorated, the first cell controller 200-1 may electrically disconnect the first battery cell 120-1 from other battery cells by controlling the switch 600. As the deteriorated first battery cell 120-1 is disconnected, performance degradation of the battery module 100 may be prevented.

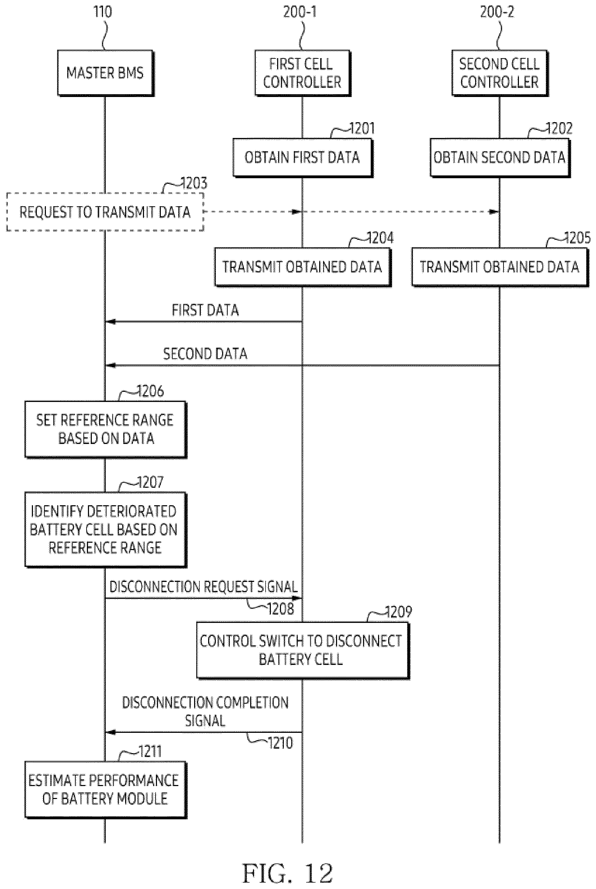

FIG. 12 is a flowchart illustrating an example of an operation in which a master BMS of a battery module separates a deteriorated battery cell, according to an embodiment. Operations of the first cell controller 200-1 and the second cell controller 200-2 described with reference to FIG. 12 may be equally applied to cell controllers of remaining battery cells.

In operation 1201, the first cell controller 200-1 may be configured to obtain first data related to the deterioration of a first battery cell (e.g., the first battery cell 120-1 of FIG. 6). For example, the first cell controller 200-1 may be configured to obtain first data on at least one of SOC changes according to voltage, current, temperature, charging and/or discharging of the first battery cell 120-1. According to an embodiment, the master BMS 110 may be configured to predesignate the type of data. For example, the master BMS 110 may designate the first cell controller 200-1 to obtain data including information on the temperature of the first battery cell 120-1. The first data may indicate a degree of deterioration of the first battery cell 120-1.

According to an embodiment, the first cell controller 200-1 may be configured to obtain the first data independently of whether the first battery cell 120-1 is activated. For example, in a state that the first battery cell 120-1 is activated, the first cell controller 200-1 may be configured to measure the temperature, operating voltage, and/or operating current of the first battery cell 120-1 and obtain first data related to the measured temperature, operating voltage and/or operating current. For example, in a state that the first battery cell 120-1 is in an inactivated state (e.g., a sleep state or a turn-off state), the first cell controller 200-1 may be configured to measure the open voltage of the first battery cell 120-1 and obtain first data related to the measured open voltage. The above-described data is merely exemplary and is not limited thereto.

In operation 1202, the second cell controller 200-2 may be configured to obtain second data related to the deterioration of a second battery cell (e.g., the second battery cell 120-2 of FIG. 6). Operation 1202 may be referred to as operation 1201.

In operation 1203, the master BMS 110 may be configured to request the first cell controller 200-1 and the second cell controller 200-2 to transmit the obtained data. For example, in operation 1203, the master BMS 110 may transmit a signal requesting the first cell controller 200-1 and the second cell controller 200-2 to transmit the obtained data. The signal may be transmitted from the master BMS 110 to the first cell controller 200-1 through a bus bar (e.g., the bus bar 500 of FIG. 6). In case that the plurality of cells 120 are connected in series, the signal may be transmitted from the master BMS 110, by passing through the first battery cell 120-1, to the second cell controller 200-2via the bus bar 500. The first cell controller 200-1 may be configured to amplify the signal when the signal passes through the first battery cell 120-1 and then transmit the amplified signal to the second battery cell 120-2. For example, the master BMS 110 may transmit a signal to the first cell controller 200-1 and the second cell controller 200-2 every cycle designated by the user. For example, when a specified event occurs, the master BMS 110 may transmit the signal to the first cell controller 200-1 and the second cell controller 200-2.

According to an embodiment, operation 1203 may be omitted. In case that operation 1203 is omitted, the first cell controller 200-1 and the second cell controller 200-2 may perform operation 1204 without a separate request from the master BMS 110. According to an embodiment, operation 1203 may be performed based on states of the first battery cell 120-1 and the second battery cell 120-2. According to an embodiment, in a first state in which the first battery cell 120-1 and the second battery cell 120-2 operate, the first cell controller 200-1 may be configured to not receive a separate request signal from the master BMS 110 and transmit the obtained data to the master BMS 110 via the bus bar 500. The first state may mean a state in which the first battery cell 120-1 and the second battery cell 120-2 supply power to a load. In the first state, the first cell controller 200-1 and the second cell controller 200-2 may be configured to transmit the obtained data to the master BMS 110. According to an embodiment, operation 1203 may be performed in a second state distinct from the first state. The second state may mean a turn-off state, a low power operation state, or a sleep state in which the first battery cell 120-1 and the second battery cell 120-2 do not supply power to a load. In the second states of the first and second battery cells 120-1 and 120-2, the master BMS 110 may be configured to transmit a signal for requesting transmission of the data to the first cell controller 200-1 and the second cell controller 200-2. Since power consumption of the first battery cell 120-1 and the second battery cell 120-2 may need to be minimized in the second state, the first cell controller 200-1 and the second cell controller 200-2 may be configured to transmit the data to the master BMS 110 when the signal is received. For example, when the first cell controller 200-1 and the second cell controller 200-2 continuously perform the operation of transmitting data to the master BMS 110 in a situation where the driving power of the load is insufficient, a situation in which the load cannot be driven due to the lack of power may occur. The first cell controller 200-1 and the second cell controller 200-2 may minimize power consumption of the first battery cell 120-1 and the second battery cell 120-2 due to the data transmission.

In operation 1204, the first cell controller 200-1 may be configured to transmit the obtained first data related to the deterioration of the first battery cell 120-1 to the master BMS 110. For example, the first cell controller 200-1 may transmit the first data to the master BMS 110 based on receiving a signal requesting transmission of the first data from the master BMS 110. For example, the first cell controller 200-1 may transmit the obtained first data to the master BMS 110 every cycle designated by the user. For example, when a specified event occurs, the first cell controller 200-1 may transmit the first data to the master BMS 110.

In operation 1205, the second cell controller 200-2 may be configured to transmit the obtained second data related to the deterioration of the second battery cell 120-2 to the master BMS 110. When the plurality of cells 120 are connected in series, the second data may pass through the first battery cell 120-1 and be transmitted to the master BMS 110. Operation 1205 may be referred to as operation 1204.

In operation 1206, the master BMS 110 may be configured to set a reference range based on the first data and the second data obtained from the first cell controller 200-1 and the second cell controller 200-2. The reference range may mean a range related to a degree of a deterioration of each of the plurality of battery cells 120. The reference range may be set to a range indicating a degree of a deterioration of a battery cell based on a type of data. For example, when the first data and the second data include information on a temperature of the battery cell, the reference range may mean a temperature range of a battery cell in a normal state. For example, in case that the first data and the second data include information on the SOC when the battery cell is charged, the reference range may mean a rate of change of the SOC over time of the battery cell in a normal state. The normal state may mean a state of a battery cell that is not deteriorated.

According to an embodiment, in order to determine the deterioration of each of the plurality of battery cells 120, the master BMS 110 may be configured to determine a reference range relatively determined according to the SOH of the plurality of battery cells 120 rather than a predetermined reference range. The determination of the deterioration of the plurality of battery cells 120 may vary according to device, environment, frequency, and the like in which the battery module 100 is used. The master BMS 110 may be configured to set a relative reference range through data related to the deterioration of the plurality of battery cells 120. According to an embodiment, the master BMS 110 may appropriately determine the degradation of the battery cell according to a situation, as compared to a case where the degradation of the battery cell is determined through a fixed reference range.

According to an embodiment, the master BMS 110 may be configured to receive data related to the deterioration of each of the plurality of battery cells 120 from the plurality of battery cells 120. The master BMS 110 may identify data having the smallest degree of deterioration among the received data. The master BMS 110 may be configured to set the reference range based on data having the smallest degree of deterioration.

For example, when the degree of deterioration of the second battery cell 120-2 is the smallest among the plurality of battery cells 120, the master BMS 110 may set the reference range based on the second data. The reference range may be set such that a difference from a value of the second data is less than or equal to a certain value. For example, when a difference between the value of the second data and the value of the first data is less than or equal to a certain value, it may be determined that the first battery cell 120-1 is not deteriorated. For example, when the difference between the value of the second data and the value of the first data is greater than or equal to a certain value, it may be determined that first battery cell 120-1 is deteriorated.

In operation 1207, the master BMS 110 may be configured to identify whether each of the plurality of battery cells 120 is deteriorated based on the reference range. The master BMS 110 may be configured to identify a deteriorated battery cell among the plurality of battery cells 120. According to an embodiment, the master BMS 110 may identify data that is not included within a reference range determined based on data having the smallest degree of deterioration. For example, in case that the reference range is set based on the second data, the master BMS 110 may identify the degradation of the first battery cell 120-1, based on identifying that the difference between the value of the second data and the value of the first data deviates from the reference range.

In operation 1208, the master BMS 110 may transmit a separation request signal requesting separation from other battery cells of the deteriorated battery cell to the cell controller included in the deteriorated battery cell, in order to electrically disconnect the deteriorated battery cell from other battery cells. For example, the master BMS 110 may be configured to transmit, to the first cell controller 200-1, a signal to disconnect the first battery cell 120-1 from the second battery cell 120-2, based on identifying that the first data deviates from the reference range. For example, when it is identified that data including information on the temperature of the first battery cell 120-1 received from the first cell controller 200-1 is not within the reference range, the master BMS 110 may transmit the first signal to the first cell controller 200-1. The first signal may be transmitted from the master BMS 110 to the first cell controller 200-1 via the bus bar 500.

In operation 1209, the cell controller disposed in the deteriorated battery cell may be configured to control the switch 600 to electrically disconnect the deteriorated battery cell from other battery cells. For example, the first cell controller 200-1 may be configured to control the switch 600 to electrically disconnect the first battery cell 120-1 from the second battery cell 120-2, based on receiving the separation request signal from the master BMS 110. For example, the first cell controller 200-1 may control a first switch (e.g., the first switch 600-1 of FIG. 7) and a second switch (e.g., the second switch 600-2 of FIG. 7) to be connected to a second line based on receiving the separation request signal. The first battery cell 120-1 being electrically disconnected from the second battery cell 120-2 may mean that the first battery cell 120-1 is electrically disconnected from other battery cells except for the first battery cell 120-1 in the battery module 100. Even when the first battery cell 120-1 is electrically disconnected from the remaining battery cells, the first battery cell 120-1 may maintain an electrical connection with the master BMS 110. The master BMS 110 may continuously manage the SOH of the separated first battery cell 120-1. In operation 1208 and operation 1209, it is described that the switch 600 is controlled by the first cell controller 200-1, but is not limited thereto. For example, the master BMS 110 may electrically disconnect the first battery cell 120-1 from the second battery cell 120-2 by directly controlling the switch 600 based on identifying that the first data deviates from the reference range.

In operation 1210, the first cell controller 200-1 may be configured to transmit, to the master BMS 110, a signal for notifying that the first battery cell 120-1 has been electrically disconnected from the second battery cell 120-2. The first cell controller 200-1 may control the switch 600 and then transmit the signal to the master BMS 110. The signal may be transmitted from the first cell controller 200-1 to the master BMS 110 via the bus bar 500.

In operation 1211, the master BMS 110 may be configured to estimate the performance of the battery module 100 composed of the plurality of battery cells 120, based on data received from the plurality of battery cells 120 and/or a connection state of the plurality of battery cells 120. The master BMS 110 may estimate SOH of each of the plurality of battery cells 120 and estimate the performance of the battery module 100 composed of the plurality of battery cells 120. The master BMS 110 may estimate the performance of the battery module 100 based on the connection states of the plurality of battery cells 120. For example, in a state that the first battery cell 120-1 is electrically disconnected from other battery cells, the master BMS 110 may estimate the performance of the battery module 100 by remaining battery cells except for the first battery cell 120-1. The master BMS 110 may notify the user of the estimated performance of the battery module 100.

According to an embodiment, the master BMS 110 may be configured to notify that the first battery cell 120-1 has been electrically disconnected from the second battery cell 120-2. For example, the master BMS 110, which is a component of a device including the battery module 100, may transmit a signal indicating that the first battery cell 120-1 has been disconnected. For example, in an electric vehicle including the battery module 100, the master BMS 110 may transmit to the user a visual or audible signal to notify that the user that the first battery cell 120-1 has been separated, through a display or speaker. Through the notification, the user may recognize that the first battery cell 120-1 is deteriorated.

The battery module 100 according to an embodiment may identify whether each of the plurality of battery cells 120 is deteriorated through the plurality of cell controllers 200 disposed in the plurality of battery cells 120 electrically connected to each other. In general, in order to identify the deterioration of the battery cell, it is required to perform a separate experiment, such as charging and discharging a battery cell. The battery module 100 according to an embodiment may easily obtain data related to the deterioration by the plurality of cell controllers 200 included in each of the plurality of battery cells 120. Since the obtained data may be transmitted to the master BMS 110 via the bus bar 500, a separate wire harness for communication is not required. Accordingly, the weight of the entire system may be lightened, and design may be facilitated. The master BMS 110 may determine whether each of the plurality of battery cells 120 is deteriorated, based on the received data. As the deteriorated battery cell is separated, performance degradation of the battery module 100 due to the deteriorated battery cell may be prevented.

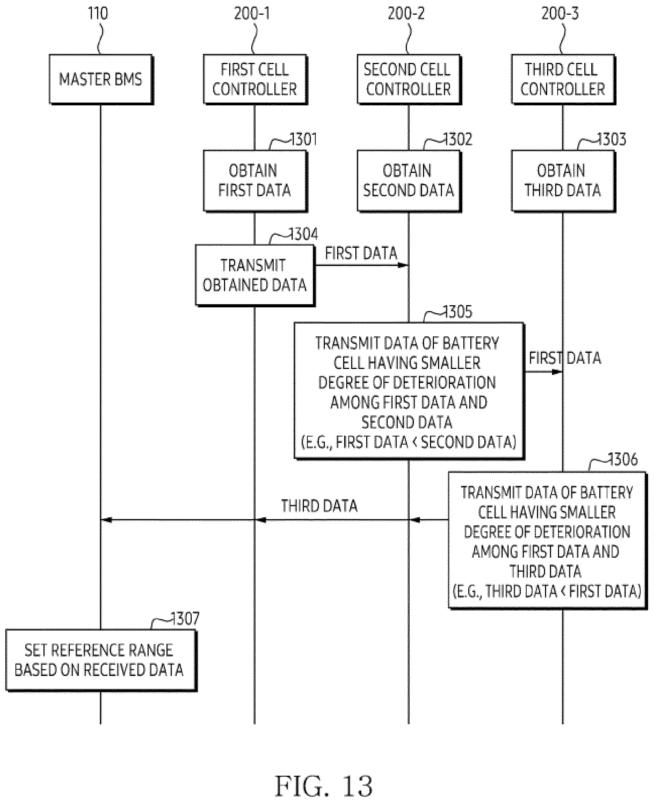

FIG. 13 is a flowchart illustrating an example of an operation in which a master BMS sets a reference range. Operations of the first to third cell controllers 200-1, 200-2, and 200-3 described with reference to FIG. 13 may be equally applied to cell controllers of the remaining battery cells.

Referring to FIG. 13, in operation 1301, the first cell controller 200-1 may be configured to obtain first data related to the deterioration of a first battery cell (e.g., the first battery cell 120-1 of FIG. 6). The first data may indicate a degree of deterioration of the first battery cell 120-1. For example, the first cell controller 200-1 may be configured to obtain first data on at least one of SOC changes according to voltage, current, temperature, charging and/or discharge of the first battery cell 120-1. According to an embodiment, the master BMS 110 may be configured to predesignate the type of data. For example, the master BMS 110 may designate the first cell controller 200-1 to obtain data including information on the temperature of the first battery cell 120-1.

In operation 1302, the second cell controller 200-2 may be configured to obtain second data related to the deterioration of a second battery cell (e.g., the second battery cell 120-2 of FIG. 6). In operation 1303, the third cell controller 200-3 may be configured to obtain third data related to the deterioration of a third battery cell (e.g., the third battery cell 120-3 of FIG. 6). Operation 1302 and operation 1303 may be referred to as operation 1301.

In operation 1304, the first cell controller 200-1 may be configured to transmit the first data to the second battery cell 120-2 connected to the first battery cell 120-1. The first cell controller 200-1 may transmit the first data to the second battery cell 120-2 via the bus bar 500.

In operation 1305, the second cell controller 200-2 may be configured to compare the first data received from the first cell controller 200-1 and the second data, and transmit data of a battery cell having a smaller degree of deterioration to the third battery cell 120-3. For example, among a degree of deterioration of the first battery cell 120-1 identified based on the first data and a degree of deterioration of the second battery cell 120-2 identified based on the second data, in case that the degree of deterioration identified based on the first data is smaller, the second cell controller 200-2 may transmit the first data to the third battery cell 120-3.

In operation 1306, the third cell controller 200-3 may be configured to compare data (e.g., first data) received from the second cell controller 200-2 with the third data, and transmit data of a battery cell with a smaller degree of deterioration to the master BMS 110. The third battery cell 120-3 may transmit the data to the master BMS 110 via the bus bar 500. The data may be transmitted to the master BMS 110 via the second battery cell 120-2 and the first battery cell 120-1. For example, among the degree of deterioration of the first battery cell 120-1 identified based on the first data and the degree of deterioration of the third battery cell 120-3 identified based on the third data, in case that the degree of deterioration identified based on the third data is smaller, the third cell controller 200-3 may transmit the third data to the master BMS 110.

In operation 1307, the master BMS 110 may be configured to set a reference range based on the data received from the third cell controller 200-3. Operation 1307 may be referred to operation 1206 of FIG. 12. For example, in case that the third data is received from the third cell controller 200-3, the master BMS 110 may set a reference range based on the third data. Based on data received from an arbitrary battery cell that deviates from the reference range, the master BMS 110 may determine that the corresponding battery cell is deteriorated.

According to an embodiment, the master BMS 110 may set a reference range that is relatively determined according to the SOH of the plurality of battery cells 120. The master BMS 110 may determine whether each of the plurality of battery cells 120 is deteriorated, based on the reference range. According to an embodiment, the battery module 100 may control the plurality of battery cells 120 in a state suitable for the operation of a load.

According to an embodiment, the master BMS 110 may set a reference range, based on a degree of deterioration of a battery cell having the smallest degree of deterioration. For example, in case that the degree of deterioration of the third battery cell 120-3 is the smallest, when a difference between the degree of deterioration of the second battery cell 120-2 and the degree of deterioration of the third battery cell 120-3 deviates from the reference range, the master BMS 110 may determine that the first battery cell 120-1 is deteriorated. The master BMS 110 may directly and/or indirectly control the switch 600 to electrically disconnect the second battery cell 120-2 from other battery cells. For example, the master BMS 110 may form a current path (e.g., the current path P2 of FIG. 7B) of a path bypassing the second battery cell 120-2, by directly controlling the first switch (e.g., the first switch 600-1 of FIG. 7B) and the second switch (e.g., the second switch 600-2 of FIG. 7B) disposed on both ends of the second battery cell 120-2. For example, the master BMS 110 may transmit a control signal of the switch 600 to the second cell controller 200-2. The second cell controller 200-2 may control the first switch 600-1 and the second switch 600-2 based on receiving the signal to form a current path P2 of a path bypassing the second battery cell 120-2.

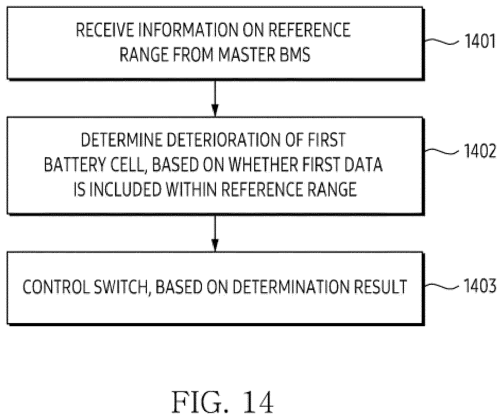

FIG. 14 is a flowchart illustrating an example of an operation in which a cell controller of a battery module separates a deteriorated battery cell, according to an embodiment. The operations of the first cell controller (e.g., the first cell controller 200-1 of FIG. 6) described with reference to FIG. 14 may be equally applied to cell controllers (e.g., the second cell controller 200-2) of the remaining battery cells.

Referring to FIG. 14, in operation 1401, the first cell controller 200-1 may be configured to receive information on a reference range from a master BMS (e.g., the master BMS 110 of FIG. 6). The reference range may be set based on data related to deterioration of each of the plurality of battery cells (e.g., the plurality of battery cells 120 of FIG. 6).

In operation 1402, the first cell controller 200-1 may be configured to determine the deterioration of the first battery cell 120-1, based on whether the first data related to the deterioration of the first battery cell (e.g., the first battery cell 120-1 of FIG. 6) is included within the reference range. The first cell controller 200-1 may determine that the first battery cell 120-1 is not deteriorated, based on identifying that the first data is included within the reference range. The first cell controller 200-1 may determine that the first battery cell 120-1 is deteriorated, based on identifying that the first data is not included within the reference range.

In operation 1403, the first cell controller 200-1 may be configured to control a switch (e.g., the switch 600 of FIG. 6) based on the determination result. For example, when it is determined that the first battery cell 120-1 is not deteriorated, the first cell controller 200-1 may connect the switch 600 to a first line (e.g., the first line L1 of FIG. 7A). For example, when it is determined that the first battery cell 120-1 is deteriorated, the first cell controller 200-1 may connect the switch 600 to a second line (e.g., the second line L2 of FIG. 7B). The first cell controller 200-1 may determine by itself whether the first battery cell 120-1 is deteriorated, based on the reference range received from the master BMS 110. The first cell controller 200-1 may control a connection state of the first battery cell 120-1 by controlling the switch 600 based on the determination result.

The above-described operations may be performed by a plurality of cell controllers (e.g., the plurality of cell controllers 200 of FIG. 6). As described with reference to FIGS. 12 and 13, the master BMS 110 may determine whether the plurality of battery cells 120 are deteriorated, or as described with reference to FIG. 14, the plurality of cell controllers 200 may determine whether the plurality of battery cells 120 are deteriorated

According to an embodiment, a battery module (e.g., the battery module 100 of FIG. 6) may comprise a plurality of battery cells (e.g., the plurality of battery cells 200 of FIG. 6), a master battery management system (BMS) (e.g., the master BMS 110 of FIG. 6), a bus bar (e.g., the bus bar 500 of FIG. 6), and a switch (e.g., the switch 600 of FIG. 6). The plurality of battery cells may include a first battery cell (e.g., the first battery cell 120-1 of FIG. 6) and a second battery sell (e.g., the second battery cell 120-2 of FIG. 6). The master BMS may be configured to manage the plurality of battery cells. The bus bar may connect the plurality of battery cells to each other. The bus bar may be electrically connected to the master BMS. The switch may be configured to electrically connect the first battery cell and the second battery cell or electrically disconnect the first battery cell and the second battery cell. The first battery cell may include a first cell controller (e.g., the first cell controller 200-1 of FIG. 6) configured to communicate with the master BMS via the bus bar. The first cell controller may be configured to obtain first data related to a deterioration of the first battery cell. The first cell controller may be configured to control the switch to electrically disconnect the first battery cell from the second battery cell, in case of determining the deterioration of the first battery cell based on the first data.

According to an embodiment, the first cell controller may be configured to transmit the first data, via the bus bar, to the master BMS. The master BMS may be configured to compare the first data received from the first cell controller with a pre-determined reference value. The master BMS may be configured to transmit a first signal to electrically disconnect the first battery cell from the second battery cell to the first cell controller, based on identifying that the first data deviates from the reference value. The first cell controller may be configured to control the switch to electrically disconnect the first battery cell from the second battery cell, based on receiving the first signal from the master BMS.

According to an embodiment, the first cell controller may be configured to, in a first state in which the first battery cell operates, transmit the first data to the master BMS, via the bus bar. The master BMS may be configured to transmit, in a second state distinct from the first state of the first battery cell, a second signal to request transmitting of the first data to first cell controller, via the bus bar. The first cell controller may be configured to transmit the first data to the master BMS, via the bus bar, based on receiving the second signal from the master BMS.

According to an embodiment, the first cell controller may be configured to compare the first data with a pre-determined reference value. The first cell controller may be configured to control the switch to electrically disconnect the first battery cell from the second battery cell, based on identifying that the first data deviates from the reference value.

According to an embodiment, the first cell controller may include memory (e.g., the memory 250 of FIG. 2) configured to store the first data. The first cell controller may be configured to transmit at least a portion of first data stored in the memory, based on receiving a third signal, from the master BMS, to request transmitting of the first data stored in the memory. The master BMS may be configured to determine the deterioration of the first battery cell, based on the first data stored in the memory, received from the first cell controller.

According to an embodiment, the master MBS may be configured to set a reference range based on data related the deterioration of each of the plurality of battery cells. The master MBS may be configured to identify whether the first battery cell is deteriorated, based on the reference range. The master MBS may be configured to control the switch, via the first cell controller, to electrically disconnect the first battery cell from the second battery cell, based on identifying the deterioration of the first battery cell.

According to an embodiment, the master BMS may be configured to transmit a first signal to electrically disconnect the first battery cell from the second battery cell to the first cell controller, based on identifying the deterioration of the first battery cell. The first cell controller may be configured to control the switch to electrically disconnect the first battery cell from the second battery cell, based on receiving the first signal from the master BMS.

According to an embodiment, the second battery cell may include a second cell controller (e.g., the second cell controller 200-2 of FIG. 6) configured to communicate with the master BMS via the bus bar. The first cell controller may be configured to obtain first data related to the deterioration of the first battery cell. The first cell controller may be configured to transmit the first data to the second battery cell connected to the first battery cell. The second cell controller may be configured to obtain second data related to a deterioration of the second battery cell. The second cell controller may be configured to transmit data with a smaller degree of deterioration among the first data and the second data to the master BMS. The master BMS may be configured to set the reference range, based on the data with a smaller degree of deterioration among the first data and the second data received from the second cell controller.

According to an embodiment, the master BMS may be configured to transmit the reference range, set based on the data with a smaller degree of deterioration among the first data and the second data, to the first battery cell. The first cell controller may be configured to control the switch to electrically disconnect the first battery cell from the second battery cell, based on identifying the first data that is not included within the reference range.

According to an embodiment, the master BMS may be configured to estimate a performance of the battery module including the plurality of battery cells, based on the data and a connection state of the plurality of battery cells.

According to an embodiment, a battery module (e.g., the battery module 100 of FIG. 6) may comprise a plurality of battery cells (e.g., the plurality of battery cells 200 of FIG. 6), a master BMS (e.g., the master BMS 110 of FIG. 6), a bus bar (e.g., the bus bar 500 of FIG. 6), a plurality of cell controllers (e.g., the plurality of cell controllers 200 of FIG. 6), and a switch (e.g., the switch 600 of FIG. 6). The plurality of battery cells may include a first battery cell (e.g., the first battery cell 120-1 of FIG. 6) and a second battery sell (e.g., the second battery cell 120-2 of FIG. 6). The master BMS may be configured to manage the plurality of battery cells. The bus bar may connect the plurality of battery cells to each other. The bus bar may be electrically connected to the master BMS. The plurality of cell controllers may be configured to communicate with the master BMS via the bus bar, wherein each of the plurality of cell controllers is disposed in each of the plurality of battery cells. The switch may be configured to electrically connect the first battery cell and the second battery cell or electrically disconnect the first battery cell and the second battery cell. The master BMS may be configured to set a reference range based on data related a deterioration of each of the plurality of battery cells. The master BMS may be configured to identify a deteriorated battery cell among the plurality of battery cells, based on the reference range. The master BMS may be configured to control the switch, via one of the plurality of cell controllers, to electrically disconnect the deteriorated battery cell from other battery cells, based on identifying the deteriorated battery cell.

According to an embodiment, the master BMS may be configured to transmit a signal to electrically disconnect the deteriorated battery cell from other battery cells to a cell controller disposed in the deteriorated battery cell. The cell controller, disposed in the deteriorated battery cell, may be configured to control the switch to electrically disconnect the deteriorated battery cell from other battery cells.

According to an embodiment, a first cell controller (e.g., the first cell controller 200-1 of FIG. 6), disposed in a first battery cell among the plurality of battery cells, may be configured to obtain first data related to a deterioration of the first battery cell. The first cell controller may be configured to transmit the first data to the second battery cell connected to the first battery cell. A second cell controller, disposed in the second battery cell, may be configured to obtain second data related to a deterioration of the second battery cell. The second cell controller may be configured to transmit data with a smaller degree of deterioration among the first data and the second data to the master BMS. The master BMS may be configured to set the reference range, based on the data with a smaller degree of deterioration among the first data and the second data received from the second cell controller.

According to an embodiment, the master BMS may be configured to transmit the reference range, set based on the data with a smaller degree of deterioration among the first data and the second data, to the first battery cell. The first cell controller may be configured to control the switch to electrically disconnect the first battery cell from the other battery cells, based on identifying the first data that is not included within the reference range.

According to an embodiment, the master BMS may be configured to estimate a performance of the battery module including the plurality of battery cells, based on the data and a connection state of the plurality of battery cells.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

Various embodiments as set forth herein may be implemented as software including one or more instructions that are stored in a storage medium that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A battery module comprising:
a plurality of battery cells including a first battery cell and a second battery sell;
a master battery management system (BMS) to manage the plurality of battery cells;
a bus bar, connecting the plurality of battery cells to each other, electrically connected to the master BMS; and
a switch configured to electrically connect the first battery cell and the second battery cell or electrically disconnect the first battery cell and the second battery cell,
wherein the first battery cell includes a first cell controller configured to communicate with the master BMS via the bus bar,
wherein the first cell controller is configured to:
obtain first data related to a deterioration of the first battery cell, and
control the switch to electrically disconnect the first battery cell from the second battery cell, in accordance with determining the deterioration of the first battery cell based on the first data.

2. The battery module of claim 1,
wherein the first cell controller is configured to transmit the first data, via the bus bar, to the master BMS, and
wherein the master BMS is configured to:
compare the first data received from the first cell controller with a pre-determined reference value, and
transmit a first signal to electrically disconnect the first battery cell from the second battery cell to the first cell controller, based on identifying that the first data deviates from the reference value, and
wherein the first cell controller is configured to control the switch to electrically disconnect the first battery cell from the second battery cell, based on receiving the first signal from the master BMS.

3. The battery module of claim 2,
wherein the first cell controller is configured to, in a first state in which the first battery cell operates, transmit the first data to the master BMS, via the bus bar,
wherein the master BMS is configured to transmit, in a second state distinct from the first state of the first battery cell, a second signal to request transmitting of the first data to first cell controller, via the bus bar, and
wherein the first cell controller is configured to transmit the first data to the master BMS, via the bus bar, based on receiving the second signal from the master BMS.

4. The battery module of claim 1,
wherein the first cell controller is configured to:
compare the first data with a pre-determined reference value, and
control the switch to electrically disconnect the first battery cell from the second battery cell, based on identifying that the first data deviates from the reference value.

5. The battery module of claim 1,
wherein the first cell controller includes memory configured to store the first data, and is configured to transmit at least a portion of first data stored in the memory, based on receiving a third signal, from the master BMS, to request transmitting of the first data stored in the memory, and
wherein the master BMS is configured to determine the deterioration of the first battery cell, based on the first data stored in the memory, received from the first cell controller.

6. The battery module of claim 1,
wherein the master MBS is configured to:
set a reference range based on data related the deterioration of each of the plurality of battery cells,
identify whether the first battery cell is deteriorated, based on the reference range, and
control the switch, via the first cell controller, to electrically disconnect the first battery cell from the second battery cell, based on identifying the deterioration of the first battery cell.

7. The battery module of claim 6,
wherein the master BMS is configured to transmit a first signal to electrically disconnect the first battery cell from the second battery cell to the first cell controller, based on identifying the deterioration of the first battery cell, and
wherein the first cell controller is configured to control the switch to electrically disconnect the first battery cell from the second battery cell, based on receiving the first signal from the master BMS.

8. The battery module of claim 6,
wherein the second battery cell includes a second cell controller configured to communicate with the master BMS via the bus bar,
wherein the first cell controller is configured to:
obtain first data related to the deterioration of the first battery cell, and
transmit the first data to the second battery cell connected to the first battery cell,
wherein the second cell controller is configured to:
obtain second data related to a deterioration of the second battery cell, and
transmit data with a smaller degree of deterioration among the first data and the second data to the master BMS, and
wherein the master BMS is configured to set the reference range, based on the data with a smaller degree of deterioration among the first data and the second data received from the second cell controller.

9. The battery module of claim 8,
wherein the master BMS is configured to transmit the reference range, set based on the data with a smaller degree of deterioration among the first data and the second data, to the first battery cell, and
wherein the first cell controller is configured to control the switch to electrically disconnect the first battery cell from the second battery cell, based on identifying the first data that is not included within the reference range.

10. The battery module of claim 6,
wherein the master BMS is configured to estimate a performance of the battery module including the plurality of battery cells, based on the data and a connection state of the plurality of battery cells.

11. A battery module comprising:
a plurality of battery cells including a first battery cell and a second battery sell;
a master BMS to manage the plurality of battery cells;
a bus bar, connecting the plurality of battery cells to each other, electrically connected to the master BMS;
a plurality of cell controllers configured to communicate with the master BMS via the bus bar, wherein each of the plurality of cell controllers is disposed in each of the plurality of battery cells; and
a switch configured to electrically connect the first battery cell and the second battery cell or electrically disconnect the first battery cell and the second battery cell,
wherein the master BMS is configured to:
set a reference range based on data related a deterioration of each of the plurality of battery cells,
identify a deteriorated battery cell among the plurality of battery cells, based on the reference range, and
control the switch, via one of the plurality of cell controllers, to electrically disconnect the deteriorated battery cell from other battery cells, based on identifying the deteriorated battery cell.

12. The battery module of claim 11,
wherein the master BMS is configured to transmit a signal to electrically disconnect the deteriorated battery cell from other battery cells to a cell controller disposed in the deteriorated battery cell, and
wherein the cell controller, disposed in the deteriorated battery cell, is configured to control the switch to electrically disconnect the deteriorated battery cell from other battery cells.

13. The battery module of claim 11,
wherein a first cell controller, disposed in a first battery cell among the plurality of battery cells, is configured to:
obtain first data related to a deterioration of the first battery cell, and
transmit the first data to the second battery cell connected to the first battery cell,
wherein a second cell controller, disposed in the second battery cell, is configured to:
obtain second data related to a deterioration of the second battery cell, and
transmit data with a smaller degree of deterioration among the first data and the second data to the master BMS, and
wherein the master BMS is configured to set the reference range, based on the data with a smaller degree of deterioration among the first data and the second data received from the second cell controller.

14. The battery module of claim 13,
wherein the master BMS is configured to transmit the reference range, set based on the data with a smaller degree of deterioration among the first data and the second data, to the first battery cell, and
wherein the first cell controller is configured to control the switch to electrically disconnect the first battery cell from the other battery cells, based on identifying the first data that is not included within the reference range.

15. The battery module of claim 11,
wherein the master BMS is configured to estimate a performance of the battery module including the plurality of battery cells, based on the data and a connection state of the plurality of battery cells.
